# EUROPEAN PATENT APPLICATION

(11) **EP 4 636 011 A1**
(43) Date of publication of application: **22.10.2025**
(21) Application number: 25171113.1
(22) Date of filing: 16.04.2025
(51) Int. Cl.: C08G 73/10, C08G 73/16, C09D 179/08, G03F 7/004, G03F 7/037, G03F 7/038

(54) **POLYMER, NEGATIVE PHOTOSENSITIVE RESIN COMPOSITION, PATTERNING PROCESS, METHOD FOR FORMING CURED FILM, INTERLAYER INSULATING FILM, SURFACE PROTECTIVE FILM, AND ELECTRONIC COMPONENT**

(30) Priority: 18.04.2024 JP 2024067161
(71) Applicant: SHIN-ETSU CHEMICAL CO., LTD., Tokyo 1000005 (JP)
(72) Inventor: Urano, Hiroyuki, Niigata, 942-8601 (JP); Iio, Masashi, Niigata, 942-8601 (JP); Watanabe, Osamu, Niigata, 942-8601 (JP); Takemura, Katsuya, Niigata, 942-8601 (JP)
(74) Representative: Schicker, Silvia

(57) **Abstract**

The present invention is a polymer having a polyimide precursor, where the polymer contains a structural unit represented by the following general formula (1), wherein at least one of R₁-R₄ represents a monovalent organic group having 1 to 15 carbon atoms; and at least one of Ra and Rb represents an organic group comprising an alpha,beta-unsaturated ester, such as an acrylic ester. This can provide: a polymer having a polyimide precursor, usable as a base resin for a negative photosensitive resin composition which enables fine pattern formation, provides high resolution, and has excellent mechanical characteristics even when cured at low temperatures; and a negative photosensitive resin composition which includes the polymer, and in patterning, is excellent in resolution and enables fine pattern formation, and has excellent mechanical characteristics even when cured at low temperatures.

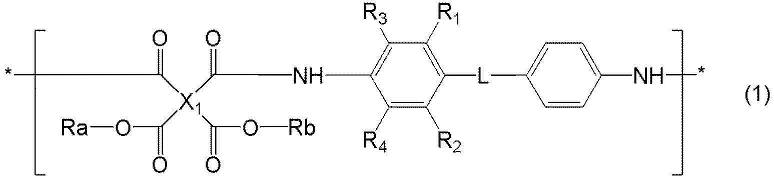

## Description

### TECHNICAL FIELD

The present invention relates to: a polymer having a polyimide precursor; a negative photosensitive resin composition; a patterning process; a method for forming a cured film; an interlayer insulating film; a surface protective film; and an electronic component.

### BACKGROUND ART

As miniaturization and higher performance of various electronic devices such as personal computers, digital cameras, and mobile phones advance, demands for further miniaturization, thinning, and higher density in semiconductor devices are also increasing rapidly. Accompanying these, it is demanded for interlayer insulating films and surface protective films of semiconductor devices to combine better electric characteristics, heat resistance, mechanical characteristics, and the like.

In a high-density mounting technology such as a three-dimensional lamination, as a photosensitive insulation material capable of forming a pattern on a substrate, a polyimide film has been utilized as a protective film or an insulation layer, its insulation property, mechanical characteristics, adhesiveness with a substrate, and so forth have continued to draw attention, and its development is active even now.

Conventionally, as a photosensitive polyimide-based material, there is a proposal for a material containing a polyamic acid, being a precursor of a polyimide, for example, a material in which a photosensitive group has been introduced into a carboxy group of a polyamic acid via an ester bond (Patent Document 1). However, in the proposal of Patent Document 1, after a patterned film is formed, an imidization treatment at a high temperature of over 300°C is essential for obtaining the target polyimide film, and to withstand this high temperature, there have been problems that the underlying substrate is limited and the copper of circuits is oxidized.

In addition, to improve the mechanical strength of a cured film, a composition containing a polymer having a structural unit derived from ester-containing diamine is proposed (Patent Document 2, Patent Document 3). Patent Document 2 proposes a positive photosensitive resin composition containing an esterdiamine-containing polybenzoxazole precursor and a naphthoquinonediazide compound. However, regarding lithography characteristics, only dissolution contrast and sensitivity are described and there is no description regarding pattern resolution, and there is also room for improvement regarding the value of mechanical strength.

Patent Document 3 proposes a polyamic acid and a polyimide obtained by the ring closure of the polyamic acid, containing, as a diamine residue, a diamine residue derived from an ester-containing diamine and a flexible diamine, and an acid dianhydride residue. However, there is no description regarding photosensitive resin compositions, and there is room for improvement regarding mechanical strength, especially elongation.

Thus, hereafter, as higher densification and higher integration of chips proceed, the miniaturization of patterns in a rewiring technology of the insulation protective film further proceeds. Accordingly, as the photosensitive resin composition, there is strong demand for a composition that can realize high resolution and a pattern profile with good rectangularity without damaging excellent features such as the mechanical characteristics and adhesiveness of a pattern and a protective film obtained by heating.

### CITATION LIST

### PATENT LITERATURE

Patent Document 1: JP H6-342211 A
Patent Document 2: JP 2020-152768 A
Patent Document 3: JP 2021-187934 A

### SUMMARY OF INVENTION

### TECHNICAL PROBLEM

The present invention has been made in view of the above-described circumstances. An object of the present invention is to provide a polymer having a polyimide precursor, usable as a base resin for a negative photosensitive resin composition which enables fine pattern formation, provides high resolution, and has excellent mechanical characteristics even when cured at low temperatures.

Another object of the present invention is to provide a negative photosensitive resin composition which includes the polymer, and in patterning, is excellent in resolution and enables fine pattern formation, and has excellent mechanical characteristics even when cured at low temperatures.

### SOLUTION TO PROBLEM

To achieve the object, the present invention provides a polymer having a polyimide precursor, wherein the polymer comprises a structural unit represented by the following general formula (1), 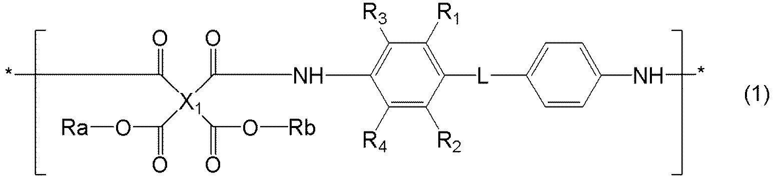 wherein X₁ represents a tetravalent organic group; R₁ to R₄ are each different from or identical to each other and represent a monovalent organic group having 1 to 15 carbon atoms and optionally containing a heteroatom or represent a hydrogen atom, provided that at least one of R₁ to R₄ represents a monovalent organic group having 1 to 15 carbon atoms and optionally containing a heteroatom; L represents a divalent linking group; Ra and Rb each independently represent a hydrogen atom, a linear, branched, or cyclic alkyl group having 1 to 6 carbon atoms, or an organic group represented by the following general formula (2), provided that at least one of Ra and Rb represents an organic group represented by the following general formula (2), 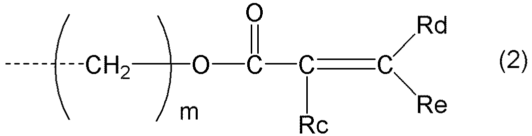 wherein a dotted line represents an attachment point; Rc represents a hydrogen atom or an organic group having 1 to 3 carbon atoms; Rd and Re each independently represent a hydrogen atom or an organic group having 1 to 3 carbon atoms; and "m" represents an integer of 2 to 10.

Such a polymer has a polymerizable unsaturated bond group in a structural unit, and therefore, has a characteristic that when combined with a photo-radical initiator, described later, radical polymerization progresses with radicals generated in exposed portions being the initiator in patterning, and the polymer is provided with insolubility in a developing solution. Therefore, it is possible to give a negative photosensitive resin composition even without newly adding a crosslinking agent. In addition, suitable interaction between molecules is promoted by the general formula (1) having a phenyl group having a substituent, and thus, the polymer is usable as a base resin of a photosensitive resin composition having excellent mechanical properties even when cured at low temperatures.

In the polymer, it is preferable that, in the general formula (1), either one of the R₁ and the R₂ represents a monovalent organic group having 1 to 15 carbon atoms and optionally containing a heteroatom, the other of the R₁ and the R₂ represents a hydrogen atom, and the R₃ and the R₄ each represent a hydrogen atom.

A photosensitive resin composition containing such a polymer has a substituent at an ortho position of an attachment point, and therefore, free rotation of the polymer chain is suppressed by the steric hindrance of the substituent, so that suitable interaction between molecules can be achieved. Thus, the composition has excellent mechanical properties even when cured at low temperatures.

In this case, it is preferable that, in the general formula (1), either one of the R₁ and the R₂ represents an aromatic group having 6 to 12 carbon atoms, and the other of the R₁ and the R₂ represents a hydrogen atom.

A photosensitive resin composition containing such a polymer has better mechanical properties even when cured at low temperatures.

In the polymer, the L in the general formula (1) is preferably at least one atom or organic group selected from any of an oxygen atom, a sulfur atom, an ester group, a carbonyl group, a linear alkylene group having 1 to 15 carbon atoms, and a branched alkylene group having 3 to 15 carbon atoms, particularly preferably a least one atom or organic group selected from either of an oxygen atom and an ester group.

A photosensitive resin composition containing such a polymer has excellent mechanical properties by flexibility being imparted to the polymer chain.

The present invention further provides a negative photosensitive resin composition comprising:
(A) a polymer having a polyimide precursor containing a structural unit represented by the general formula (1);
(B) a photo-radical initiator; and
(E) a solvent.

As described above, the polymer having the polyimide precursor containing the structural unit represented by the general formula (1) has a polymerizable unsaturated bond group in the polymer molecule, and therefore, a negative photosensitive resin composition can be obtained by the combination of the polymer and the photo-radical initiator.

The negative photosensitive resin composition preferably further comprises, as a component (C), a crosslinking agent having two or more photopolymerizable unsaturated bond groups in one molecule.

When a crosslinking agent having two or more photopolymerizable unsaturated bonds in one molecule is contained as described above, it is possible to promote further the crosslinking in exposed portions by photopolymerization and improve the contrast between exposed portions and unexposed portions.

The negative photosensitive resin composition preferably further comprises, as (D) a heat crosslinking agent, one or more crosslinking agents selected from the group consisting of an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (D-1), and a compound containing two or more nitrogen atoms each having a glycidyl group represented by the following formula (D-2), 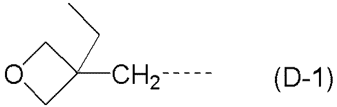 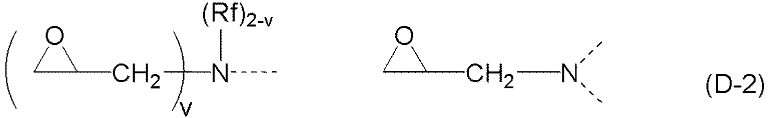 wherein a dotted line represents an attachment point; Rf represents a linear, branched, or cyclic alkyl group having 1 to 6 carbon atoms; and "v" represents 1 or 2.

When the component (D) is contained, the crosslinking density of the cured film is increased by the component (D) crosslinking with the component (A) at the time of post-curing, and excellent mechanical strength can be achieved.

The negative photosensitive resin composition can further comprise one or more of (F) a protective amine compound, (G) a thermal acid generator, (H) an antioxidant, and (I) a silane compound.

The component (F) generates a basic compound during high-temperature curing and serves as a catalyst of a crosslinking reaction, and can promote the curing reaction.

The component (G) can further improve the mechanical strength, chemical resistance, adhesiveness, etc. of the obtained pattern or film by further promoting the crosslinking and curing reactions.

The component (H) can suppress the degradation of physical properties of a cured film due to degradation by oxidation in reliability tests, such as a high humidity test and a thermal shock test, and a more suitable cured film can be formed.

The component (I) can further enhance the adhesiveness of the obtained pattern or film to a substrate.

Furthermore, the present invention provides a patterning process comprising the steps of:
(1) applying the above-described negative photosensitive resin composition onto a substrate to form a photosensitive material film;
(2) heating the photosensitive material film;
(3) exposing the photosensitive material film with a high-energy beam having a wavelength of 190 to 500 nm or an electron beam through a photomask; and
(4) performing development using a developing solution of an organic solvent.

Such a patterning process uses in particular, as a base resin, a polymer having a polymerizable unsaturated bond group, and such a patterning process enables excellent resolution and the formation of a fine pattern, and makes it possible to form a pattern excellent in mechanical characteristics even when curing is performed at low temperatures.

Furthermore, the present invention provides a method for forming a cured film, comprising heating and post-curing a patterned film obtained by the above-described patterning process at a temperature of 100 to 300°C.

According to such a method for forming a cured film, an imide ring-closing reaction occurs in the structural unit of the polyimide precursor in the inventive polymer and a very stable film of a polyimide resin is formed, and thus, a cured film (pattern) with favorable mechanical properties can be formed.

Furthermore, the present invention provides an interlayer insulating film or surface protective film comprising a cured film of the above-described negative photosensitive resin composition.

The cured film formed by curing the inventive negative photosensitive resin composition is excellent in adhesiveness to a substrate, heat resistance, electrical properties, mechanical strength, and chemical resistance to alkaline stripping solution etc. Moreover, a semiconductor device using the cured film as a protection film is also excellent in reliability. Therefore, the cured film is suitable as a protective film (interlayer insulating film or surface protective film) for electrical and electronic components, semiconductor devices, etc.

Furthermore, the present invention provides an electronic component comprising the above-described interlayer insulating film or surface protective film.

Because of the heat resistance, chemical resistance, and insulating property, such a protective film (interlayer insulating film or surface protective film) is effective as an insulating film for semiconductor devices including a rewiring application, an insulating film for multilayer printed circuit boards, etc. Thus, the protective film can achieve an electronic component excellent in reliability.

### ADVANTAGEOUS EFFECTS OF INVENTION

As described above, according to the present invention, it is possible to provide a polymer having a polyimide precursor, usable as a base resin for a negative photosensitive resin composition which enables fine pattern formation, provides high resolution, and has excellent mechanical characteristics even when cured at low temperatures.

Also, it is possible to provide a negative photosensitive resin composition which includes the polymer, and in patterning, is excellent in resolution and enables fine pattern formation, and has excellent mechanical characteristics even when cured at low temperatures.

### DESCRIPTION OF EMBODIMENTS

As described above, there has been demand for a polymer usable as a base resin for a photosensitive resin composition which enables fine pattern formation, provides high resolution, and has excellent mechanical characteristics even when cured at low temperatures.

To achieve the object, the present inventors have earnestly studied and found out that when a polymer having a polyimide precursor containing a structural unit represented by the following general formula (1) is used as a base resin for a photosensitive resin composition, such a polymer can be utilized for a negative photosensitive resin composition to allow development with an organic solvent, and that patterns obtained by using the negative photosensitive resin composition are fine and have favorable pattern shapes.

Furthermore, the present inventors have found that a protective film excellent in mechanical strength and adhesiveness is obtained by using a photosensitive resin composition containing as a base resin a polymer having the polyimide, and by subjecting the composition to patterning and then heating at low temperatures. That is, the obtained cured film having a pattern formed using the photosensitive resin composition containing a base resin of a polymer having the structural unit is excellent as an insulating protective film and a protective film for electrical and electronic components. These findings have led to the completion of the present invention. Note that, in the specification, electrical and electronic components are also altogether referred to as "electronic components".

That is, the present invention is a polymer having a polyimide precursor containing a structural unit represented by the following general formula (1), 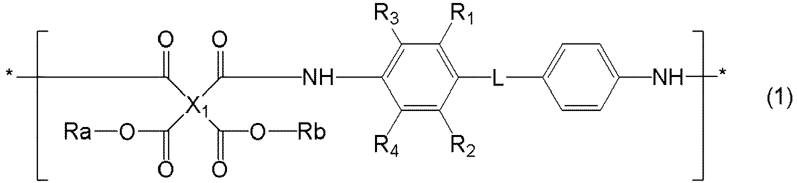 wherein X₁ represents a tetravalent organic group; R₁ to R₄ are each different from or identical to each other and represent a monovalent organic group having 1 to 15 carbon atoms and optionally containing a heteroatom or represent a hydrogen atom, provided that at least one of R₁ to R₄ represents a monovalent organic group having 1 to 15 carbon atoms and optionally containing a heteroatom; L represents a divalent linking group; Ra and Rb each independently represent a hydrogen atom, a linear, branched, or cyclic alkyl group having 1 to 6 carbon atoms, or an organic group represented by the following general formula (2), provided that at least one of Ra and Rb represents an organic group represented by the following general formula (2), 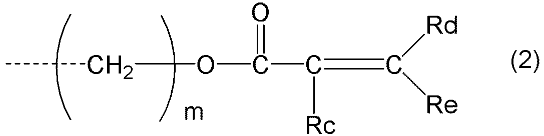 wherein a dotted line represents an attachment point; Rc represents a hydrogen atom or an organic group having 1 to 3 carbon atoms; Rd and Re each independently represent a hydrogen atom or an organic group having 1 to 3 carbon atoms; and "m" represents an integer of 2 to 10.

Hereinafter, the present invention will be described in detail, but the present invention is not limited thereto.

### [(A) Polymer]

The inventive polymer has a polyimide precursor, and contains a structural unit represented by the following general formula (1). 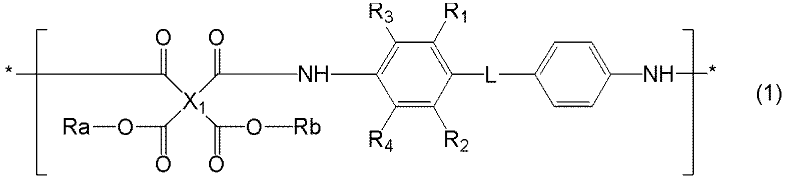 In the formula, X₁ represents a tetravalent organic group; R₁ to R₄ are each different from or identical to each other and represent a monovalent organic group having 1 to 15 carbon atoms and optionally containing a heteroatom or represent a hydrogen atom, provided that at least one of R₁ to R₄ represents a monovalent organic group having 1 to 15 carbon atoms and optionally containing a heteroatom; L represents a divalent linking group; Ra and Rb each independently represent a hydrogen atom, a linear, branched, or cyclic alkyl group having 1 to 6 carbon atoms, or an organic group represented by the following general formula (2), provided that at least one of Ra and Rb represents an organic group represented by the following general formula (2). 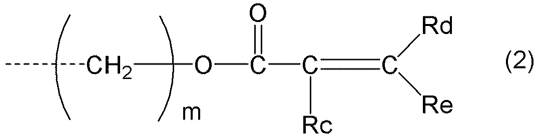 In the formula, a dotted line represents an attachment point; Rc represents a hydrogen atom or an organic group having 1 to 3 carbon atoms; Rd and Re each independently represent a hydrogen atom or an organic group having 1 to 3 carbon atoms; and "m" represents an integer of 2 to 10.

The X₁ in the general formula (1) is a tetravalent organic group, and is not limited as long as it is a tetravalent organic group. X₁ is preferably a tetravalent alicyclic aliphatic group having 4 to 40 carbon atoms or a tetravalent aromatic group having 6 to 40 carbon atoms and optionally contains a siloxane skeleton. X₁ is further preferably a tetravalent organic group represented by one of the following formulae (3). In addition, the structure of X₁ may be of one kind or a combination of two or more kinds. 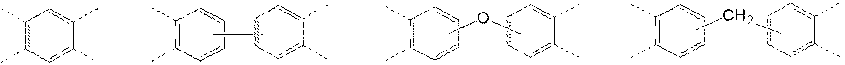 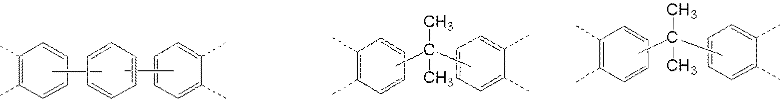 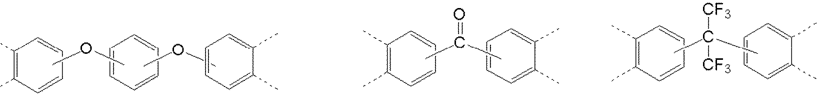 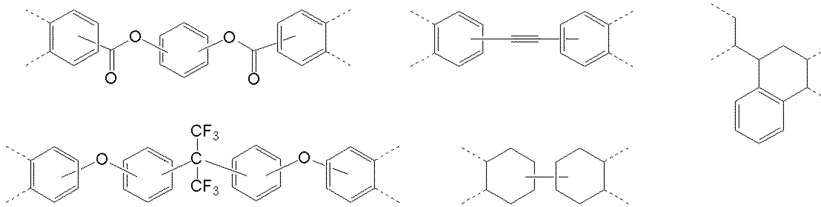 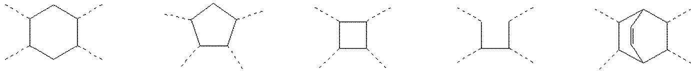 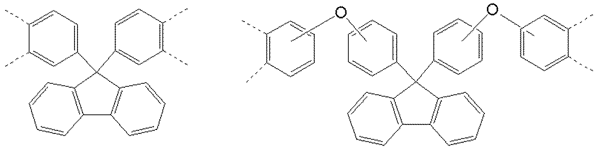 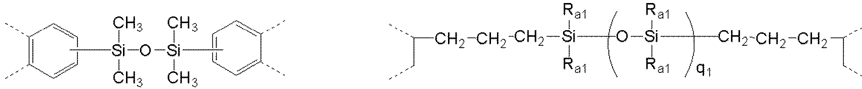 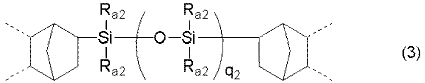 In the formulae, Rₐ₁ and Rₐ₂ each independently represent a methyl group or a phenyl group, "q₁" and "q₂" each represent an integer of 1 to 20, and a dotted line represents an attachment point.

At least one of the R₁ to R₄ in the general formula (1) represents a monovalent organic group having 1 to 15 carbon atoms and optionally containing a heteroatom. Preferably, either one of the R₁ and the R₂ represents a monovalent organic group having 1 to 15 carbon atoms and optionally containing a heteroatom, the other of the R₁ and the R₂ represents a hydrogen atom, and the R₃ and the R₄ each represent a hydrogen atom. More preferably, either one of the R₁ and the R₂ represents a group selected from an alkyl group having 1 to 12 carbon atoms, an alkoxy group having 1 to 12 carbon atoms, an aromatic group having 6 to 12 carbon atoms, a phenoxy group having 6 to 10 carbon atoms, a benzyl group having 7 to 10 carbon atoms, and a benzyloxy group having 7 to 10 carbon atoms, the other of the R₁ and the R₂ represents a hydrogen atom, and the R₃ and the R₄ each represent a hydrogen atom. Further preferably, either one of the R₁ and the R₂ represents a monovalent organic group having 1 to 10 carbon atoms and optionally containing a heteroatom, the other of the R₁ and the R₂ represents a hydrogen atom, and the R₃ and the R₄ each represent a hydrogen atom.

Examples of the alkyl group having 1 to 12 carbon atoms include a methyl group, an ethyl group, a propyl group, an isopropyl group, a butyl group, an isobutyl group, a pentyl group, a hexyl group, etc. Examples of the alkoxy group having 1 to 12 carbon atoms include a methoxy group, an ethoxy group, a propoxy group, a butoxy group, a pentoxy group, etc. Examples of the aromatic group having 6 to 12 carbon atoms include a phenyl group, a methylphenyl group, a dimethylphenyl group, an ethylphenyl group, a diethylphenyl group, a propylphenyl group, a butylphenyl group, a fluorophenyl group, a chlorophenyl group, a bromophenyl group, a methoxyphenyl group, a dimethoxyphenyl group, an ethoxyphenyl group, a diethoxyphenyl group, an aminophenyl group, a nitrophenyl group, a cyanophenyl group, a phenethyl group, a phenylpropyl group, a phenylamino group, a diphenylamino group, a biphenyl group, a naphthyl group, etc. Examples of the phenoxy group having 6 to 10 carbon atoms include a methylphenoxy group, an ethylphenoxy group, a propylphenoxy group, a dimethylphenoxy group, a diethylphenoxy group, a methoxyphenoxy group, an ethoxyphenoxy group, a dimethoxyphenoxy group, etc. Examples of the benzyl group having 7 to 10 carbon atoms include a benzyl group, a methylbenzyl group, an ethylbenzyl group, a propylbenzyl group, a dimethylbenzyl group, a diethylbenzyl group, a methoxybenzyl group, an ethoxybenzyl group, a dimethoxybenzyl group, a diethoxybenzyl group, an aminobenzyl group, a nitrobenzyl group, a cyanobenzyl group, etc. Examples of the benzyloxy group having 7 to 10 carbon atoms include a benzyloxy group, a methylbenzyloxy group, an ethylbenzyloxy group, a propylbenzyloxy group, a dimethylbenzyloxy group, a diethylbenzyloxy group, a methoxybenzyloxy group, an ethoxybenzyloxy group, etc.

Out of the above, an aromatic group having 6 to 12 carbon atoms, a phenoxy group having 6 to 10 carbon atoms, a benzyl group having 7 to 10 carbon atoms, and a benzyloxy group having 7 to 10 carbon atoms are preferable, an aromatic group having 6 to 12 carbon atoms is more preferable, and a phenyl group, a methylphenyl group, a dimethylphenyl group, an ethylphenyl group, and a diethylphenyl group are further preferable. It is thought that such an organic group suppresses the free rotation of the polymer chain by the bulkiness of the organic group, thus suppressing the packing effect between molecules, so that suitable interaction between the molecules is achieved and the mechanical properties, especially rupture elongation, of the cured film are improved.

In the general formula (1), the L represents a divalent linking group, and is not particularly limited. The L is preferably any of an oxygen atom, a sulfur atom, an ester group, a carbonyl group, a linear alkylene group having 1 to 15 carbon atoms, or a branched alkylene group having 3 to 15 carbon atoms. The L is further preferably an oxygen atom or an ester group. Such an organic group promotes interaction between molecules by a hydrogen bond or the like, and in addition, by also interacting with the substrate, can achieve excellent mechanical characteristics and excellent adhesiveness to the substrate even when curing is performed at low temperatures.

The Ra and the Rb in the general formula (1) each independently represent a hydrogen atom, a linear, branched, or cyclic alkyl group having 1 to 6 carbon atoms, or an organic group represented by the general formula (2), provided that at least one of Ra and Rb represents an organic group represented by the general formula (2).

The Rc in the general formula (2) is not limited as long as it is a hydrogen atom or a monovalent organic group having 1 to 3 carbon atoms, but from the viewpoint of the photosensitivity of the negative photosensitive resin composition, a hydrogen atom or a methyl group is preferable.

The Rd and the Re in the general formula (2) are not limited as long as they each independently represent a hydrogen atom or a monovalent organic group having 1 to 3 carbon atoms, but from the viewpoint of the photosensitivity of the negative photosensitive resin composition, a hydrogen atom is preferable.

The "m" in the general formula (2) represents an integer of 2 to 10, and from the viewpoint of photosensitivity, preferably an integer of 2 to 4. Further preferably, "m" represents 2.

The inventive polymer can further contain, in addition to the structural unit represented by the general formula (1), any one or more of structural units represented by the following general formulae (4) to (7). 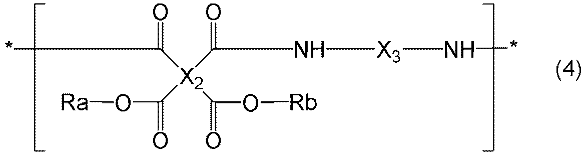 In the formula, X₂ represents a tetravalent organic group that is identical to or different from the above-described X₁, X₃ represents a divalent organic group, and Ra and Rb are as defined above. 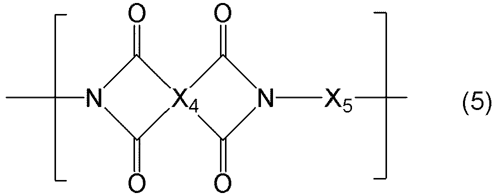 In the formula, X₄ represents a tetravalent organic group that is identical to or different from the above-described X₁, and X₅ represents a divalent organic group that is identical to or different from the above-described X₃. 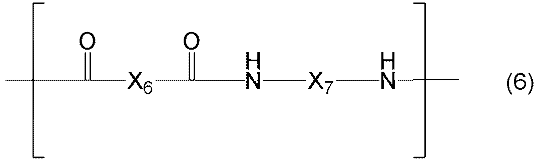 In the formula, X₆ represents a divalent organic group, and X₇ represents a divalent organic group that is identical to or different from the above-described X₃. 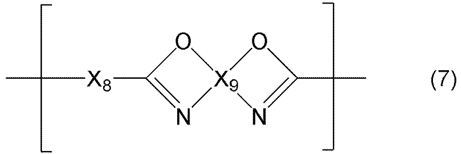 In the formula, X₈ represents a divalent organic group that is identical to or different from the above-described X₆, and X₉ represents a tetravalent organic group.

The X₂ in the general formula (4) represents a tetravalent organic group, is identical to or different from the above-described X₁, and is not limited as long as it is a tetravalent organic group. The X₂ is preferably a tetravalent alicyclic aliphatic group having 4 to 40 carbon atoms or a tetravalent aromatic group having 6 to 40 carbon atoms, and optionally contains a siloxane skeleton. The X₂ is further preferably a tetravalent organic group represented by one of the formulae (3). In addition, the structure of X₂ may be of one kind or a combination of two or more kinds.

The X₃ in the general formula (4) is a divalent organic group and is not limited as long as it is a divalent organic group. The X₃ is preferably a divalent organic group having 6 to 40 carbon atoms, more preferably a divalent cyclic organic group containing 1 to 4 aromatic rings or aliphatic rings each having a substituent, a divalent aliphatic group not having a cyclic structure, or a siloxane group. Further suitable examples of X₃ include structures represented by the following formulae (8) or (9). In addition, the structure of X₃ may be of one kind or a combination of two or more kinds. 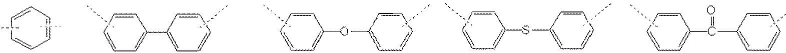 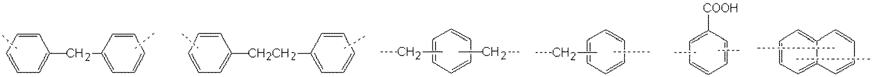 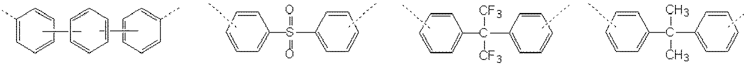 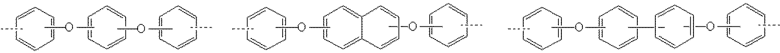 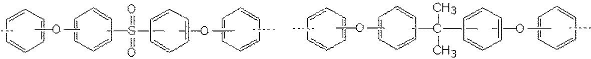 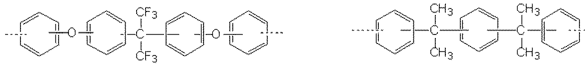 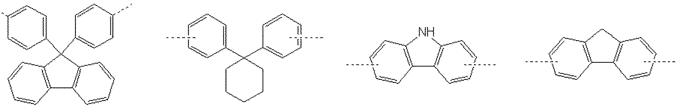 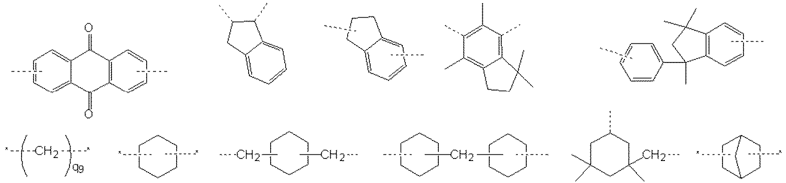 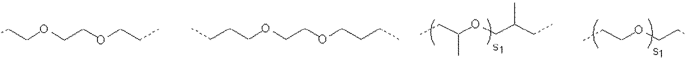 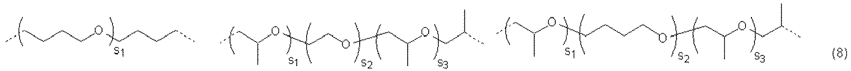 In the formulae, "q₉" represents an integer of 1 to 20, "s₁" represents an integer of 1 to 40, "s₂" and "s₃" each independently represent an integer of 0 to 40, and a dotted line represents an attachment point. 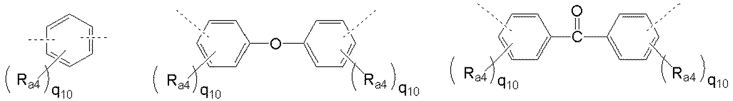 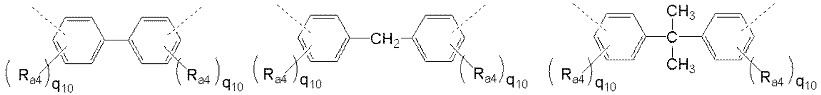 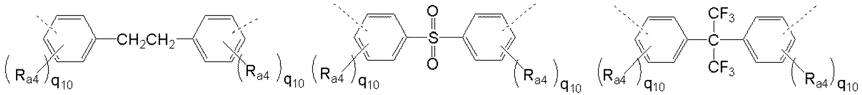 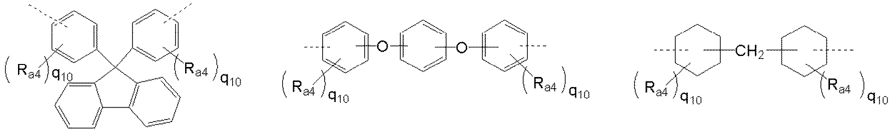 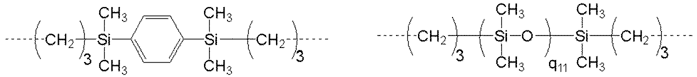 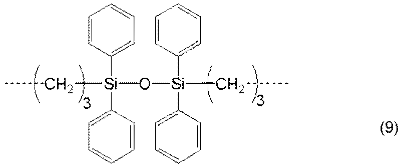 In the formulae, "q₁₀" represents an integer of 1 to 4, Rₐ₄ represents a fluorine atom, a methyl group, an ethyl group, a propyl group, an n-butyl group, a methoxy group, an ethoxy group, a propoxy group, a butoxy group, or a trifluoromethyl group, the Rₐ₄s are identical to or different from each other when "q₁₀" is 2 or more, "q₁₁" represents an integer of 1 to 40, and a dotted line represents an attachment point.

A resin composition containing a polymer containing a structural unit represented by the general formula (4) has a polymerizable unsaturated bond group in the structural unit, and therefore, in pattern formation, becomes insoluble in developing solutions by radical polymerization progressing in exposed portions in addition to the structural unit represented by the general formula (1). Therefore, such a composition is preferable, since resolution in a negative photosensitive resin composition can be improved.

The X₄ in the general formula (5) represents a tetravalent organic group and is identical to or different from the above-described X₁, and is not limited as long as it is a tetravalent organic group. The X₄ is preferably a tetravalent alicyclic aliphatic group having 4 to 40 carbon atoms or a tetravalent aromatic group having 6 to 40 carbon atoms, and optionally contains a siloxane skeleton. The X₄ is further preferably a tetravalent organic group represented by one of the formulae (3). In addition, the structure of X₄ may be of one kind or a combination of two or more kinds.

The X₅ in the general formula (5) represents a divalent organic group, is identical to or different from the above-described X₃, and is not limited as long as it is a divalent organic group. The X₅ is preferably a divalent organic group having 6 to 40 carbon atoms, more preferably a divalent cyclic organic group containing 1 to 4 aromatic rings or aliphatic rings each having a substituent, a divalent aliphatic group not having a cyclic structure, or a siloxane group. Further suitable examples of X₅ include the structures represented by the formulae (8) or (9). In addition, the structure of X₅ may be of one kind or a combination of two or more kinds.

The resin composition containing the polymer containing the structural unit represented by the general formula (5) is preferable because it is possible to enhance the mechanical strength, adhesive force to substrate, and heat resistance of the cured film obtained by patterning. Moreover, the structural unit (5) does not require ring-closing reaction in post-curing, so that the curing reaction temperature can be reduced relatively, which is preferable.

The X₆ in the general formula (6) represents a divalent organic group, and is not limited as long as it is a divalent organic group. The X₆ is preferably a divalent organic group having an aliphatic chain length structure having 4 to 40 carbon atoms, a divalent alicyclic aliphatic group having 4 to 40 carbon atoms, or a divalent aromatic group having 6 to 40 carbon atoms. The X₆ is further preferably a divalent organic group represented by one of the following formulae (10). In addition, the structure of X₆ may be of one kind or a combination of two or more kinds. 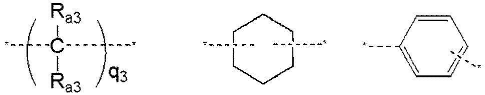 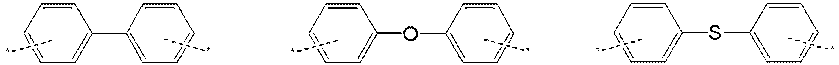 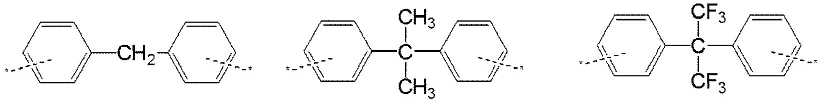 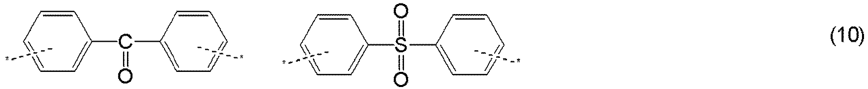 In the formulae, each Rₐ₃ independently represents a hydrogen atom, a fluorine atom, or an alkyl group having 1 to 6 carbon atoms, "q₃" represents an integer of 1 to 30, and a dotted line represents an attachment point.

The X₇ in the general formula (6) represents a divalent organic group, is identical to or different from the above-described X₃, and is not limited as long as it is a divalent organic group. The X₇ is preferably a divalent organic group having 6 to 40 carbon atoms, a divalent cyclic organic group containing 1 to 4 aromatic rings or aliphatic rings each having a substituent, a divalent aliphatic group not having a cyclic structure, or a siloxane group. Further preferable examples include the structures represented by the formulae (8) or (9). In addition, the structure of X₇ may be of one kind or a combination of two or more kinds.

The resin composition containing the polymer containing the structural unit represented by the general formula (6) is preferable because it is possible to enhance mechanical properties, such as elongation, and adhesive force to substrate of the cured film obtained by patterning.

The X₈ in the general formula (7) is a divalent organic group and is identical to or different from the above-described X₆, and is not limited as long as it is a divalent organic group. The X₈ is preferably a divalent organic group having an aliphatic chain length structure having 4 to 40 carbon atoms, a divalent alicyclic aliphatic group having 4 to 40 carbon atoms, or a divalent aromatic group having 6 to 40 carbon atoms. The X₈ is further preferably a divalent organic group represented by one of the formulae (10). In addition, the structure of X₈ may be of one kind or a combination of two or more kinds.

The X₉ in the general formula (7) is a tetravalent organic group and is not limited as long as it is a tetravalent organic group. The X₉ is preferably a tetravalent organic group having 6 to 40 carbon atoms, more preferably a tetravalent cyclic organic group containing 1 to 4 aromatic rings or aliphatic rings each having a substituent, a tetravalent aliphatic group not having a cyclic structure, or a siloxane group. Further suitable examples of the X₉ include structures represented by the following formulae (11). In addition, the structure of X₉ may be of one kind or a combination of two or more kinds. 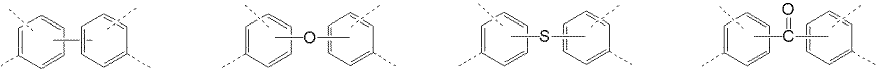 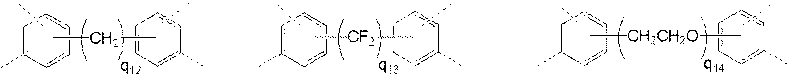 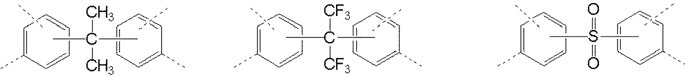 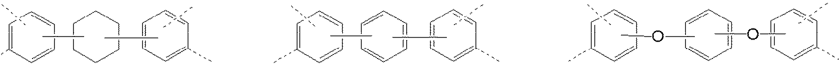 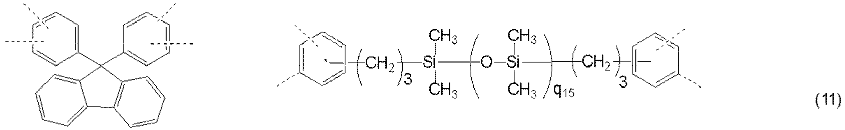 In the formulae, "q₁₂", "q₁₃", and "q₁₄" each represent an integer of 1 to 10, "q₁₅" represents an integer of 1 to 20, and a dotted line represents an attachment point.

The resin composition containing the polymer containing the structural unit represented by the general formula (7) is preferable because it is possible to enhance the mechanical strength, adhesive force to substrate, and heat resistance of the cured film obtained by patterning. Moreover, when the structure represented by the general formula (7) is contained, a ring-closure reaction is not required in post-curing, so that the curing reaction temperature can be reduced relatively, which is preferable.

A suitable molecular weight for the inventive polymer is preferably 5,000 to 100,000, more preferably 7,000 to 50,000. When the molecular weight is 5,000 or more, it is easy to form a film of a photosensitive resin composition containing the inventive polymer on a substrate in such a manner as to achieve a desired film thickness. When the molecular weight is 100,000 or less, the photosensitive resin composition has a suitable viscosity, and there are no problems in film formation. Note that, in the present invention, the weight-average molecular weight is a value obtained by gel permeation chromatography (GPC) in terms of polystyrene.

### [Method for Manufacturing Polymer]

The inventive polymer has a polyimide precursor, and contains a structural unit represented by the following general formula (1). 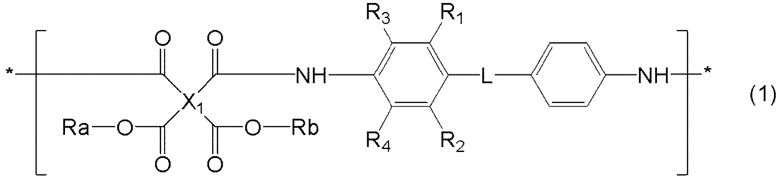 In the formula, X₁, R₁ to R₄, Ra, Rb, and L are as defined above.

A polymer containing the structural unit represented by the general formula (1) can be obtained by allowing a tetracarboxylic acid diester compound represented by the following general formula (12) to react with a diamine represented by the following general formula (13).

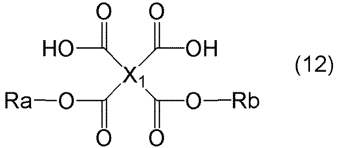

In the formula, X₁, Ra, and Rb are as defined above. 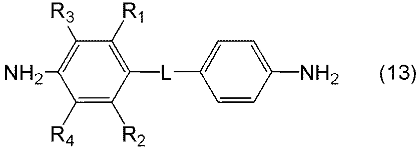 In the formula, R₁ to R₄ and L are as defined above.

In the general formula (12), at least one of Ra and Rb is an organic group represented by the general formula (2), and the organic group represented by the general formula (2) can be introduced by allowing a tetracarboxylic dianhydride represented by the following general formula (14) to react with a compound represented by the following general formula (15), having a hydroxy group on an end, in the presence of a basic catalyst such as pyridine. Here, the tetracarboxylic dianhydride represented by the following general formula (14) is to be a source of the X₁ (e.g. a tetravalent organic group represented by one of the formulae (3)) in the general formula (1), and the compound represented by the following general formula (15) having a hydroxy group on an end makes it possible to introduce the organic group represented by the general formula (2). 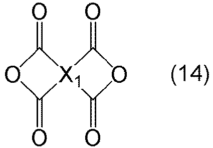 In the formula, X₁ is as defined above. 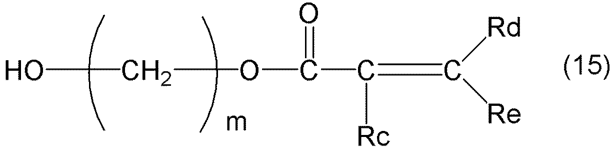 In the formula, Rc, Rd, Re, and "m" are as defined above.

Suitable examples of the tetracarboxylic dianhydride represented by the general formula (14) include aromatic acid dianhydrides, alicyclic acid dianhydrides, aliphatic acid dianhydrides, siloxane skeleton-containing acid dianhydrides, etc.

Examples of the aromatic acid dianhydride include, but are not limited to, for example, pyromellitic dianhydride, 3,3',4,4'-biphenyltetracarboxylic dianhydride, 2,3,3',4'-biphenyltetracarboxylic dianhydride, 2,3,2',3'-biphenyltetracarboxylic dianhydride, 3,3',4,4'-terphenyltetracarboxylic dianhydride, 3,3',4,4'-oxyphthalic dianhydride, 2,3,3',4'-oxyphthalic dianhydride, 2,3,2',3'-oxyphthalic dianhydride, diphenylsulfone-3,3',4,4'-tetracarboxylic dianhydride, benzophenone-3,3',4,4'-tetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, 1,4-(3,4-dicarboxyphenoxy)benzene dianhydride, p-phenylenebis(trimellitic acid monoester acid anhydride), bis(1,3-dioxo-1,3-dihydroisobenzfuran-5-carboxylic acid)1,4-phenylene, 2,2-bis(4-(4-aminophenoxy)phenyl)propane, 1,2,5,6-naphthalenetetracarboxylic dianhydride, 2,3,6,7-naphthalenetetracarboxylic dianhydride, 9,9-bis(3,4-dicarboxyphenyl) fluorene dianhydride, 9,9-bis(4-(3,4-dicarboxyphenoxy) phenyl) fluorene dianhydride, 2,3,5,6-pyridinetetracarboxylic dianhydride, 3,4,9,10-perylenetetracarboxylic dianhydride, 2,2-bis(3,4-dicarboxyphenyl)hexafluoropropane dianhydride, 2,2-bis(4-(3,4-dicarboxybenzoyloxy)phenyl)hexafluoropropane dianhydride, 1,6-difluoropyromellitic dianhydride, 1-trifluoromethylpyromellitic dianhydride, 1,6-ditrifluoromethylpyromellitic dianhydride, 2,2'-bis(trifluoromethyl)-4,4'-bis(3,4-dicarboxyphenoxy)biphenyl dianhydride, 2,2'-bis[(dicarboxyphenoxy)phenyl]propane dianhydride, 2,2'-bis[(dicarboxyphenoxy)phenyl]hexafluoropropane dianhydride, and acid dianhydride compounds formed by substituting aromatic rings of the above compounds with an alkyl group, an alkoxy group, a halogen atom, or the like.

Examples of the alicyclic acid dianhydride include, but are not limited to, for example, 1,2,3,4-cyclobutanetetracarboxylic dianhydride, 1,2,3,4-cyclopentanetetracarboxylic dianhydride, 1,2,4,5-cyclohexanetetracarboxylic dianhydride, 1,2,4,5-cyclopentanetetracarboxylic dianhydride, 1,2,3,4-tetramethyl-1,2,3,4-cyclobutanetetracarboxylic dianhydride, 1,2-dimethyl-1,2,3,4-cyclobutanetetracarboxylic dianhydride, 1,3-dimethyl-1,2,3,4-cyclobutanetetracarboxylic dianhydride, 1,2,3,4-cycloheptanetetracarboxylic dianhydride, 2,3,4,5-tetrahydrofurantetracarboxylic dianhydride, 3,4-dicarboxy-1-cyclohexylsuccinic dianhydride, 2,3,5-tricarboxycyclopentylacetic dianhydride, 3,4-dicarboxy-1,2,3,4-tetrahydro-1-naphthalenesuccinic dianhydride, bicyclo[3.3.0]octane-2,4,6,8-tetracarboxylic dianhydride, bicyclo[4.3.0]nonane-2,4,7,9-tetracarboxylic dianhydride, bicyclo[4.4.0]decane-2,4,7,9-tetracarboxylic dianhydride, bicyclo[4.4.0]decane-2,4,8,10-tetracarboxylic dianhydride, tricyclo[6.3.0.0^{2,6}]undecane-3,5,9,11-tetracarboxylic dianhydride, bicyclo[2.2.2]octane-2,3,5,6-tetracarboxylic dianhydride, bicyclo[2.2.2]oct-7-ene-2,3,5,6-tetracarboxylic dianhydride, bicyclo[2.2.1]heptanetetracarboxylic dianhydride, bicyclo[2.2.1]heptane-5-carboxymethyl-2,3,6-tricarboxylic dianhydride, 7-oxabicyclo[2.2.1]heptane-2,4,6,8-tetracarboxylic dianhydride, octahydronaphthalene-1,2,6,7-tetracarboxylic dianhydride, tetradecahydroanthracene-1,2,8,9-tetracarboxylic dianhydride, 3,3',4,4'-dicyclohexanetetracarboxylic dianhydride, 3,3',4,4'-oxydicyclohexanetetracarboxylic dianhydride, 5-(2,5-dioxotetrahydro-3-furanyl)-3-methyl-3-cyclohexene-1,2-dicarboxylic anhydride, and "RIKACID" (Registered Trademark) BT-100 (trade name, manufactured by New Japan Chemical Co., Ltd.) and derivatives thereof, or acid dianhydride compounds formed by substituting aliphatic rings of the above compounds with an alkyl group, an alkoxy group, a halogen atom or the like.

Examples of the aliphatic acid dianhydride include, but are not limited to, for example, 1,2,3,4-butanetetracarboxylic dianhydride, 1,2,3,4-pentanetetracarboxylic dianhydride, and derivatives thereof.

Examples of the siloxane skeleton-containing acid dianhydride include, but are not limited to, for example, 1,3-bis(3,4-dicarboxyphenyl)-1,1,3,3-tetramethyldisiloxane dianhydride, 3,3'-((1,1,3,3-tetramethyl-1,3-disiloxanediyl)di-3,1-propanediyl)bis(dihydro-2,5-furandione), and derivatives thereof.

Any one of these aromatic acid dianhydrides, alicyclic acid dianhydrides, aliphatic acid dianhydrides, or siloxane skeleton-containing acid dianhydrides may be used, or two or more thereof may be used in combination.

The Rc in the general formula (15) is not limited as long as it is a hydrogen atom or a monovalent organic group having 1 to 3 carbon atoms, but from the viewpoint of the photosensitivity of the negative photosensitive resin composition, a hydrogen atom or a methyl group is preferable.

The Rd and the Re in the general formula (15) are not limited as long as they are each independently a hydrogen atom or a monovalent organic group having 1 to 3 carbon atoms, but from the viewpoint of the photosensitivity of the negative photosensitive resin composition, a hydrogen atom is preferable.

The "m" in the general formula (15) represents an integer of 2 to 10, and from the viewpoint of photosensitivity, preferably an integer of 2 to 4. More preferably, "m" is 2.

Among compounds represented by the general formula (15) having a hydroxy group on an end, examples of suitable compounds include 2-acryloyloxyethyl alcohol, 1-acryloyloxy-3-propyl alcohol, 2-methacryloyloxyethyl alcohol, and 1-methacryloyloxy-3-propyl alcohol.

The Ra and the Rb in the general formula (12) may each be a linear, branched, or cyclic alkyl group having 1 to 6 carbon atoms. Examples of methods for introducing a linear, branched, or cyclic alkyl group having 1 to 6 carbon atoms to the general formula (12) (that is, providing a linear, branched, or cyclic alkyl group having 1 to 6 carbon atoms as Ra and Rb) include a method in which, in a reaction between the compound represented by the general formula (15) having a hydroxy group on an end and tetracarboxylic dianhydride performed in the presence of a basic catalyst such as pyridine, a linear, branched, or cyclic alcohol having 1 to 6 carbon atoms is introduced at the same time.

Examples of suitable alcohols that can be used in this event include methanol, ethanol, 1-propanol, 2-propanol, 1-butanol, 2-butanol, 1-pentanol, 2-pentanol, 3-pentanol, neopentyl alcohol, 1-hexanol, 2-hexanol, 3-hexanol, cyclopentanol, and cyclohexanol.

Regarding the reaction between the tetracarboxylic dianhydride represented by the general formula (14) and the compound, having a hydroxy group on an end, represented by the general formula (15), the tetracarboxylic dianhydride represented by the general formula (14) and the compound, having a hydroxy group on an end, represented by the general formula (15) are stirred, dissolved, and mixed in the presence of a basic catalyst, such as pyridine, in a reaction solvent at a reaction temperature of 20 to 50°C for 4 to 10 hours. Thus, a half-esterification reaction of an acid dianhydride progresses, and the desired tetracarboxylic acid diester compound represented by the general formula (12) can be obtained as a solution in which the compound is dissolved in the reaction solvent.

The obtained tetracarboxylic acid diester compound may be subjected to isolation, or the obtained solution may be used as it is in the subsequent reaction with the diamine described later.

The reaction solvent preferably dissolves well a polymer having a structural unit of a polyimide precursor obtained from the above-described tetracarboxylic acid diester compound and by the polycondensation reaction between the tetracarboxylic acid diester compound and a diamine performed subsequently, and examples include N-methyl-2-pyrrolidone, N,N-dimethylacetamide, N,N-dimethylformamide, dimethylsulfoxide, tetramethylurea, γ-butyrolactone, etc. It is also possible to use ketones, esters, lactones, ethers, halogenated hydrocarbons, hydrocarbons, etc., and specific examples include acetone, methyl ethyl ketone, methyl isobutyl ketone, cyclohexanone, methyl acetate, ethyl acetate, butyl acetate, diethyl oxalate, ethylene glycol dimethyl ether, diethylene glycol dimethyl ether, tetrahydrofuran, dichloromethane, 1,2-dichloroethane, 1,4-dichlorobutane, chlorobenzene, o-dichlorobenzene, hexane, heptane, benzene, toluene, xylene, etc. One of these solvents may be used or two or more thereof may be used in mixture as necessary.

Suitable examples of the diamine represented by the general formula (13) include (2-methyl-4-amino)phenyl-4-aminobenzoate, (3-methyl-4-amino)phenyl-4-aminobenzoate, (2-ethyl-4-amino)phenyl-4-aminobenzoate, (3-ethyl-4-amino)phenyl-4-aminobenzoate, (2-propyl-4-amino)phenyl-4-aminobenzoate, (3-propyl-4-amino)phenyl-4-aminobenzoate, (2-isopropyl-4-amino)phenyl-4-aminobenzoate, (3-isopropyl-4-amino)phenyl-4-aminobenzoate, (2-butyl-4-amino)phenyl-4-aminobenzoate, (3-butyl-4-amino)phenyl-4-aminobenzoate, (2-isobutyl-4-amino)phenyl-4-aminobenzoate, (3-isobutyl-4-amino)phenyl-4-aminobenzoate, (2-pentyl-4-amino)phenyl-4-aminobenzoate, (3-pentyl-4-amino)phenyl-4-aminobenzoate, (2-hexyl-4-amino)phenyl-4-aminobenzoate, (3-hexyl-4-amino)phenyl-4-aminobenzoate, (2-methoxy-4-amino)phenyl-4-aminobenzoate, (3-methoxy-4-amino)phenyl-4-aminobenzoate, (2-ethoxy-4-amino)phenyl-4-aminobenzoate, (3-ethoxy-4-amino)phenyl-4-aminobenzoate, (2-propoxy-4-amino)phenyl-4-aminobenzoate, (3-propoxy-4-amino)phenyl-4-aminobenzoate, (2-butoxy-4-amino)phenyl-4-aminobenzoate, (3-butoxy-4-amino)phenyl-4-aminobenzoate, (2-pentoxy-4-amino)phenyl-4-aminobenzoate, (3-pentoxy-4-amino)phenyl-4-aminobenzoate, (2-phenyl-4-amino)phenyl-4-aminobenzoate, (3-phenyl-4-amino)phenyl-4-aminobenzoate, (2-methylphenyl-4-amino)phenyl-4-aminobenzoate, (3-methylphenyl-4-amino)phenyl-4-aminobenzoate, (2-ethylphenyl-4-amino)phenyl-4-aminobenzoate, (3-ethylphenyl-4-amino)phenyl-4-aminobenzoate, (2-propylphenyl-4-amino)phenyl-4-aminobenzoate, (3-propylphenyl-4-amino)phenyl-4-aminobenzoate, (2-butylphenyl-4-amino)phenyl-4-aminobenzoate, (3-butylphenyl-4-amino)phenyl-4-aminobenzoate, (2-fluorophenyl-4-amino)phenyl-4-aminobenzoate, (3-fluorophenyl-4-amino)phenyl-4-aminobenzoate, (2-chlorophenyl-4-amino)phenyl-4-aminobenzoate, (3-chlorophenyl-4-amino)phenyl-4-aminobenzoate, (2-bromophenyl-4-amino)phenyl-4-aminobenzoate, (3-bromophenyl-4-amino)phenyl-4-aminobenzoate, (2-methoxyphenyl-4-amino)phenyl-4-aminobenzoate, (3-methoxyphenyl-4-amino)phenyl-4-aminobenzoate, (2-ethoxyphenyl-4-amino)phenyl-4-aminobenzoate, (3-ethoxyphenyl-4-amino)phenyl-4-aminobenzoate, (2-ethoxyphenyl-4-amino)phenyl-4-aminobenzoate, (2-aminophenyl-4-amino)phenyl-4-aminobenzoate, (3-aminophenyl-4-amino)phenyl-4-aminobenzoate, (2-nitrophenyl-4-amino)phenyl-4-aminobenzoate, (3-nitrophenyl-4-amino)phenyl-4-aminobenzoate, (2-cyanophenyl-4-amino)phenyl-4-aminobenzoate, (3-cyanophenyl-4-amino)phenyl-4-aminobenzoate, (2-phenylethyl-4-amino)phenyl-4-aminobenzoate, (3-phenylethyl-4-amino)phenyl-4-aminobenzoate, (2-phenylamino-4-amino)phenyl-4-aminobenzoate, (3-phenylamino-4-amino)phenyl-4-aminobenzoate, (2-(4,4'-biphenyl)-4-amino)phenyl-4-aminobenzoate, (3-(4,4'-biphenyl)-4-amino)phenyl-4-aminobenzoate, (2-naphthyl-4-amino)phenyl-4-aminobenzoate, (3-naphthyl-4-amino)phenyl-4-aminobenzoate, (2-methylphenoxy-4-amino)phenyl-4-aminobenzoate, (3-methylphenoxy-4-amino)phenyl-4-aminobenzoate, (2-ethylphenoxy-4-amino)phenyl-4-aminobenzoate, (3-ethylphenoxy-4-amino)phenyl-4-aminobenzoate, (2-propylphenoxy-4-amino)phenyl-4-aminobenzoate, (3-propylphenoxy-4-amino)phenyl-4-aminobenzoate, (2-methoxyphenoxy-4-amino)phenyl-4-aminobenzoate, (3-methoxyphenoxy-4-amino)phenyl-4-aminobenzoate, (2-ethoxyphenoxy-4-amino)phenyl-4-aminobenzoate, (3-ethoxyphenoxy-4-amino)phenyl-4-aminobenzoate, (2-benzyl-4-amino)phenyl-4-aminobenzoate, (3-benzyl-4-amino)phenyl-4-aminobenzoate, (2-methylbenzyl-4-amino)phenyl-4-aminobenzoate, (3-methylbenzyl-4-amino)phenyl-4-aminobenzoate, (2-ethylbenzyl-4-amino)phenyl-4-aminobenzoate, (3-ethylbenzyl-4-amino)phenyl-4-aminobenzoate, (2-propylbenzyl-4-amino)phenyl-4-aminobenzoate, (3-propylbenzyl-4-amino)phenyl-4-aminobenzoate, (2-methoxybenzyl-4-amino)phenyl-4-aminobenzoate, (3-methoxybenzyl-4-amino)phenyl-4-aminobenzoate, (2-ethoxybenzyl-4-amino)phenyl-4-aminobenzoate, (3-ethoxybenzyl-4-amino)phenyl-4-aminobenzoate, (2-aminobenzyl-4-amino)phenyl-4-aminobenzoate, (3-aminobenzyl-4-amino)phenyl-4-aminobenzoate, (2-nitrobenzyl-4-amino)phenyl-4-aminobenzoate, (3-nitrobenzyl-4-amino)phenyl-4-aminobenzoate, (2-cyanobenzyl-4-amino)phenyl-4-aminobenzoate, (3-cyanobenzyl-4-amino)phenyl-4-aminobenzoate, (2-benzyloxy-4-amino)phenyl-4-aminobenzoate, (3-benzyloxy-4-amino)phenyl-4-aminobenzoate, (2-methylbenzyloxy-4-amino)phenyl-4-aminobenzoate, (3-methylbenzyloxy-4-amino)phenyl-4-aminobenzoate, (2-ethylbenzyloxy-4-amino)phenyl-4-aminobenzoate, (3-ethylbenzyloxy-4-amino)phenyl-4-aminobenzoate, (2-propylbenzyloxy-4-amino)phenyl-4-aminobenzoate, (3-propylbenzyloxy-4-amino)phenyl-4-aminobenzoate, (2-methoxybenzyloxy-4-amino)phenyl-4-aminobenzoate, (3-methoxybenzyloxy-4-amino)phenyl-4-aminobenzoate, (2-ethoxybenzyloxy-4-amino)phenyl-4-aminobenzoate, (3-ethoxybenzyloxy-4-amino)phenyl-4-aminobenzoate, 4-(4-aminophenoxy)-3-methylbenzenamine, 4-(4-aminophenoxy)-2-methylbenzenamine, 4-(4-aminophenoxy)-3-ethylbenzenamine, 4-(4-aminophenoxy)-2-ethylbenzenamine, 4-(4-aminophenoxy)-3-propylbenzenamine, 4-(4-aminophenoxy)-2-propylbenzenamine, 4-(4-aminophenoxy)-3-isopropylbenzenamine, 4-(4-aminophenoxy)-2-isopropylbenzenamine, 4-(4-aminophenoxy)-3-butylbenzenamine, 4-(4-aminophenoxy)-2-butylbenzenamine, 4-(4-aminophenoxy)-3-isobutylbenzenamine, and

4-(4-aminophenoxy)-2-isobutylbenzenamine, 4-(4-aminophenoxy)-3-pentylbenzenamine, 4-(4-aminophenoxy)-2-pentylbenzenamine, 4-(4-aminophenoxy)-3-hexylbenzenamine, 4-(4-aminophenoxy)-2-hexylbenzenamine, 4-(4-aminophenoxy)-3-(trifluoromethyl)benzenamine, 4-(4-aminophenoxy)-2-(trifluoromethyl)benzenamine, 4-(4-aminophenoxy)-3-methoxybenzenamine, 4-(4-aminophenoxy)-2-methoxybenzenamine, 4-(4-aminophenoxy)-3-ethoxybenzenamine, 4-(4-aminophenoxy)-2-ethoxybenzenamine, 4-(4-aminophenoxy)-3-propoxybenzenamine, 4-(4-aminophenoxy)-2-propoxybenzenamine, 4-(4-aminophenoxy)-3-butoxybenzenamine, 4-(4-aminophenoxy)-2-butoxybenzenamine, 4-(4-aminophenoxy)-3-phenylbenzenamine, 4-(4-aminophenoxy)-2-phenylbenzenamine, 4-(4-aminophenoxy)-3-methylphenylbenzenamine, 4-(4-aminophenoxy)-2-methylphenylbenzenamine, 4-(4-aminophenoxy)-3-ethylphenylbenzenamine, 4-(4-aminophenoxy)-2-ethylphenylbenzenamine, 4-(4-aminophenoxy)-3-propylphenylbenzenamine, 4-(4-aminophenoxy)-2-propylphenylbenzenamine, 4-(4-aminophenoxy)-3-butylphenylbenzenamine, 4-(4-aminophenoxy)-2-butylphenylbenzenamine, 4-(4-aminophenoxy)-3-fluorophenylbenzenamine, 4-(4-aminophenoxy)-2-fluorophenylbenzenamine, 4-(4-aminophenoxy)-3-chlorophenylbenzenamine, 4-(4-aminophenoxy)-2-chlorophenylbenzenamine, 4-(4-aminophenoxy)-3-bromophenylbenzenamine, 4-(4-aminophenoxy)-2-bromophenylbenzenamine, 4-(4-aminophenoxy)-3-methoxyphenylbenzenamine, 4-(4-aminophenoxy)-2-methoxyphenylbenzenamine, 4-(4-aminophenoxy)-3-ethoxyphenylbenzenamine, 4-(4-aminophenoxy)-2-ethoxyphenylbenzenamine, 4-(4-aminophenoxy)-3-(phenylethyl)phenylbenzenamine, 4-(4-aminophenoxy)-2-(phenylethyl)phenylbenzenamine, 4-(4-aminophenoxy)-3-naphthylphenylbenzenamine, 4-(4-aminophenoxy)-2-naphthylphenylbenzenamine, 4-(4-aminophenoxy)-3-benzylphenylbenzenamine, 4-(4-aminophenoxy)-2-benzylphenylbenzenamine, 4-((4-aminophenyl)thio)-3-methylbenzenamine, 4-((4-aminophenyl)thio)-2-methylbenzenamine, 4-((4-aminophenyl)thio)-3-ethylbenzenamine, 4-((4-aminophenyl)thio)-2-ethylbenzenamine, 4-((4-aminophenyl)thio)-3-propylbenzenamine, 4-((4-aminophenyl)thio)-2-propylbenzenamine, 4-((4-aminophenyl)thio)-3-isopropylbenzenamine, 4-((4-aminophenyl)thio)-2-isopropylbenzenamine, 4-((4-aminophenyl)thio)-3-butylbenzenamine, 4-((4-aminophenyl)thio)-2-butylbenzenamine, 4-((4-aminophenyl)thio)-3-isobutylbenzenamine, 4-((4-aminophenyl)thio)-2-isobutylbenzenamine, 4-((4-aminophenyl)thio)-3-(trifluoromethyl)benzenamine, 4-((4-aminophenyl)thio)-2-(trifluoromethyl)benzenamine, 4-((4-aminophenyl)thio)-3-methoxybenzenamine, 4-((4-aminophenyl)thio)-2-methoxybenzenamine, 4-((4-aminophenyl)thio)-3-ethoxybenzenamine, 4-((4-aminophenyl)thio)-2-ethoxybenzenamine, 4-((4-aminophenyl)thio)-3-propoxybenzenamine, 4-((4-aminophenyl)thio)-2-propoxybenzenamine, 4-((4-aminophenyl)thio)-3-isopropoxybenzenamine, 4-((4-aminophenyl)thio)-2-isopropoxybenzenamine, 4-((4-aminophenyl)thio)-3-butoxybenzenamine, 4-((4-aminophenyl)thio)-2-butoxybenzenamine, 4-((4-aminophenyl)thio)-3-phenylbenzenamine, 4-((4-aminophenyl)thio)-2-phenylbenzenamine, 4-((4-aminophenyl)thio)-3-naphthylbenzenamine, 4-((4-aminophenyl)thio)-2-naphthylbenzenamine, 4-((4-aminophenyl)thio)-3-methoxyphenylbenzenamine, 4-((4-aminophenyl)thio)-2-methoxyphenylbenzenamine, 4-((4-aminophenyl)methyl)-3-methylbenzenamine, 4-((4-aminophenyl)methyl)-2-methylbenzenamine, 4-((4-aminophenyl)methyl)-3-ethylbenzenamine, 4-((4-aminophenyl)methyl)-2-ethylbenzenamine, 4-((4-aminophenyl)methyl)-3-propylbenzenamine, 4-((4-aminophenyl)methyl)-2-propylbenzenamine, 4-((4-aminophenyl)methyl)-3-isopropylbenzenamine, 4-((4-aminophenyl)methyl)-2-isopropylbenzenamine, 4-((4-aminophenyl)methyl)-3-butylbenzenamine, 4-((4-aminophenyl)methyl)-2-butylbenzenamine, 4-((4-aminophenyl)methyl)-3-isobutylbenzenamine, 4-((4-aminophenyl)methyl)-2-isobutylbenzenamine, 4-((4-aminophenyl)methyl)-3-(trifluoromethyl)benzenamine, 4-((4-aminophenyl)methyl)-2-(trifluoromethyl)benzenamine, 4-((4-aminophenyl)methyl)-3-methoxybenzenamine, 4-((4-aminophenyl)methyl)-2-methoxybenzenamine, 4-((4-aminophenyl)methyl)-3-ethoxybenzenamine, 4-((4-aminophenyl)methyl)-2-ethoxybenzenamine, 4-((4-aminophenyl)methyl)-3-propoxybenzenamine, 4-((4-aminophenyl)methyl)-2-propoxybenzenamine, 4-((4-aminophenyl)methyl)-3-isopropoxybenzenamine, 4-((4-aminophenyl)methyl)-2-isopropoxybenzenamine, 4-((4-aminophenyl)methyl)-3-butoxybenzenamine, 4-((4-aminophenyl)methyl)-2-butoxybenzenamine, 4-((4-aminophenyl)methyl)-3-phenylbenzenamine, 4-((4-aminophenyl)methyl)-2-phenylbenzenamine, 4-((4-aminophenyl)methyl)-3-naphthylbenzenamine, 4-((4-aminophenyl)methyl)-2-naphthylbenzenamine, 4-((4-aminophenyl)methyl)-3-methoxyphenylbenzenamine, 4-((4-aminophenyl)methyl)-2-methoxyphenylbenzenamine, (4-amino-2-methylphenyl) (4-aminophenyl)methanone, (4-amino-2-ethylphenyl) (4-aminophenyl)methanone, (4-amino-2-propylphenyl) (4-aminophenyl)methanone, (4-amino-2-isopropylphenyl) (4-aminophenyl)methanone, (4-amino-2-butylphenyl) (4-aminophenyl)methanone, (4-amino-2-(trifluoromethyl)phenyl)(4-aminophenyl)methanone, 4-amino-2-methoxyphenyl) (4-aminophenyl)methanone, 4-amino-2-ethoxyphenyl)(4-aminophenyl)methanone, (4-amino-2-(phenyl)phenyl) (4-aminophenyl)methanone, and (4-amino-2-(methoxyphenyl)phenyl)(4-aminophenyl)methanone. However, examples are not limited thereto.

Here, the polymer having the polyimide precursor containing the structural unit represented by the general formula (1) can be obtained by, for example, reacting a tetracarboxylic acid diester compound represented by the general formula (12) with a diamine represented by the general formula (13) in the presence of a dehydration condensation agent. That is, the polymer having the polyimide precursor containing the structural unit represented by the general formula (1) can be obtained by using the tetracarboxylic acid diester compound represented by the general formula (12) for the reaction in the state of being dissolved in the reaction solvent; adding into this reaction solution a known dehydration condensation agent (for example, dicyclohexylcarbodiimide, 1-ethoxycarbonyl-2-ethoxy-1,2-dihydroquinoline, 1,1-carbonyldioxy-di-1,2,3-benzotriazole, N,N'-disuccinimidyl carbonate or the like) and mixing the resultant mixture under ice cooling to make the tetracarboxylic acid diester compound represented by the general formula (12) into a polyacid anhydride; and then adding dropwise to this the diamine represented by the general formula (13) that has been dissolved or dispersed in a solvent separately to carry out the polycondensation.

In addition, examples of other methods of obtaining the polymer having the polyimide precursor containing the structural unit represented by the general formula (1) by reacting the tetracarboxylic acid diester compound represented by the general formula (12) with the diamine compound represented by the general formula (13) include a process in which the polymer is synthesized by converting the tetracarboxylic acid diester compound represented by the general formula (12) into an acid chloride with using a chlorinating agent such as thionyl chloride or oxalyl chloride, and reacting the acid chloride with the diamine represented by the general formula (13).

In the reaction in which the tetracarboxylic acid diester compound is converted into an acid chloride with using a chlorinating agent, a basic compound may be further used. For this basic compound, for example, pyridine, 4-dimethylaminopyridine, triethylamine, or the like can be used.

Then, by reacting the obtained acid chloride of the tetracarboxylic acid diester compound with the diamine represented by the general formula (13) in the presence of a basic catalyst, the target polymer having the polyimide precursor containing the structural unit represented by the general formula (1) can be obtained. Upon this, examples of the basic catalyst include pyridine, dimethylaminopyridine, 1,8-diazabicyclo[5.4.0]undeca-7-ene, 1,5-diazabicyclo[4.3.0]nona-5-ene, etc.

In the method of producing the inventive polymer having the polyimide precursor, the preferable solvent to be used in the process through the acid chloride well dissolves the above-described tetracarboxylic acid diester compound and an acid chloride thereof, as well as the polymer of the polyimide precursor obtained through the polycondensation reaction of them with the diamine, and a similar solvent to those given above can be used. Specific examples thereof include N-methyl-2-pyrrolidone, N,N-dimethylacetamide, N,N-dimethylformamide, dimethylsulfoxide, tetramethylurea, hexamethylphosphoric triamide, and γ-butyrolactone. In addition, other than polar solvents, ketones, esters, lactones, ethers, halogenated hydrocarbons, hydrocarbons and the like can also be used. Examples thereof include acetone, diethyl ketone, methyl ethyl ketone, methyl isobutyl ketone, cyclohexanone, methyl acetate, ethyl acetate, butyl acetate, diethyl oxalate, diethyl malonate, diethyl ether, ethylene glycol dimethyl ether, diethylene glycol dimethyl ether, tetrahydrofuran, dichloromethane, 1,2-dichloroethane, 1,4-dichlorobutane, trichloroethane, chlorobenzene, o-dichlorobenzene, hexane, heptane, octane, benzene, toluene, xylene, etc. Any one of these organic solvents may be used, or two or more thereof may be used in combination.

Furthermore, as stated above, the inventive polymer can further contain, in addition to the structural unit represented by the general formula (1), a structural unit represented by the following general formula (4). 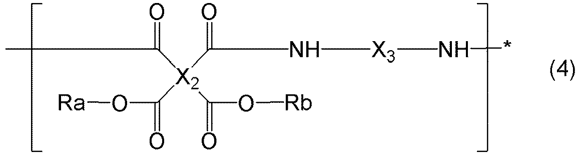 In the formula, X₂, X₃, Ra, and Rb are as defined above.

A polymer containing the structural unit represented by the general formula (4) can be obtained by performing the same reaction procedure as in the case of the structural unit (1). That is, the polymer can be obtained by performing a reaction in the presence of a dehydration condensation agent or a reaction to convert a tetracarboxylic acid diester compound represented by the following general formula (16) into an acid chloride with using a chlorinating agent, and then reacting the acid chloride with a diamine represented by the following general formula (17). 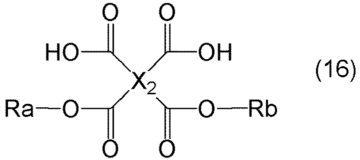 In the formula, X₂, Ra, and Rb are as defined above.

NH₂-X₃-NH₂ (17)

In the formula, X₃ is as defined above.

Regarding methods for producing the tetracarboxylic acid diester compound represented by the general formula (16), the compound can be obtained by performing the same reaction procedure as in the case of the general formula (12). That is, examples include a method of introducing the Ra and the Rb by reacting the tetracarboxylic dianhydride represented by the following general formula (18) with the compound represented by the general formula (15) having a hydroxy group on an end or with a linear, branched, or cyclic alcohol having 1 to 6 carbon atoms in the presence of a basic catalyst such as pyridine. Here, the tetracarboxylic dianhydride represented by the following general formula (18) is to be a source of the X₂ (e.g. a tetravalent organic group represented by one of the formulae (3)) in the general formula (4). 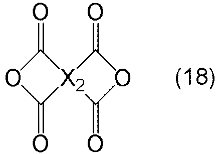 In the formula, X₂ is as defined above.

Suitable examples of the tetracarboxylic dianhydride represented by the general formula (18) include the examples given for the tetracarboxylic dianhydride represented by the general formula (14).

Examples of the diamine represented by the general formula (17) include aromatic diamines, alicyclic diamines, aliphatic diamines, polyether diamines, etc.

Examples of favorable aromatic diamines include, but are not limited to, 3,4'-diaminodiphenyl ether, 4,4'-diaminodiphenyl ether, 3,4'-diaminodiphenylmethane, 4,4'-diaminodiphenylmethane, 3,3'-diaminodiphenylsulfone, 3,4'-diaminodiphenylsulfone, 4,4'-diaminodiphenylsulfone, 3,4'-diaminodiphenylsulfide, 4,4'-diaminodiphenylsulfide, 1,4-bis(4-aminophenoxy)benzene, benzidine, 2,2'-bis(trifluoromethyl)benzidine, 3,3'-bis(trifluoromethyl)benzidine, 2,2'-dimethylbenzidine, 3,3'-dimethylbenzidine, 2,2'3,3'-tetramethylbenzidine, 2,2'-dichlorobenzidine, 3,3'-dichlorobenzidine, 2,2'3,3'-tetrachlorobenzidine, m-phenylenediamine, p-phenylenediamine, 1,5-naphthalenediamine, 2,6-naphthalenediamine, bis(4-aminophenoxyphenyl)sulfone, bis(3-aminophenoxyphenyl)sulfone, bis[4-(3-aminophenoxy)phenyl]sulfone, bis(4-aminophenoxy)biphenyl, bis{4-(4-aminophenoxy)phenyl} ether, 1,4-bis(4-aminophenoxy)benzene, 9,9-bis(4-aminophenyl) fluorene, 2,2'-bis[3-(3-aminobenzamide)-4-hydroxyphenyl]hexafluoropropane, 4-aminophenyl-4'-aminobenzoate, 4,4'-diaminobenzanilide, diamine compounds in which an aromatic ring of these compounds is substituted with an alkyl group, an alkoxy group, a halogen atom, or the like, etc.

Examples of alicyclic diamines include, but are not limited to, cyclobutanediamine, isophoronediamine, bicyclo[2,2,1]heptanebismethylamine, tricyclo[3,3,1,1^{3,7}]decane-1,3-diamine, 1,2-cyclohexyldiamine, 1,3-cyclohexyldiamine, 1,4-diaminocyclohexane, trans-1,4-diaminocyclohexane, cis-1,4-diaminocyclohexane, 4,4'-diaminodicyclohexylmethane, 3,3'-dimethyl-4,4'-diaminodicyclohexylmethane, 3,3'-diethyl-4,4'-diaminodicyclohexylmethane, 3,3',5,5'-tetramethyl-4,4'-diaminodicyclohexylmethane, 3,3',5,5'-tetraethyl-4,4'-diaminodicyclohexylmethane, 3,5-diethyl-3',5'-dimethyl-4,4'-diaminodicyclohexylmethane, 4,4'-diaminodicyclohexyl ether, 3,3'-dimethyl-4,4'-diaminodicyclohexyl ether, 3,3'-diethyl-4,4'-diaminodicyclohexyl ether, 3,3',5,5'-tetramethyl-4,4'-diaminodicyclohexyl ether, 3,3',5,5'-tetraethyl-4,4'-diaminodicyclohexyl ether, 3,5-diethyl-3',5'-dimethyl-4,4'-diaminodicyclohexyl ether, 2,2-bis(4-aminocyclohexyl) propane, 2,2-bis(3-methyl-4-aminocyclohexyl) propane, 2,2-bis(3-ethyl-4-aminocyclohexyl) propane, 2,2-bis(3,5-dimethyl-4-aminocyclohexyl) propane, 2,2-bis(3,5-diethyl-4-aminocyclohexyl) propane, 2,2-(3,5-diethyl-3',5'-dimethyl-4,4'-diaminodicyclohexyl)propane, diamine compounds in which an aliphatic ring of these compounds is substituted with an alkyl group, an alkoxy group, a halogen atom, or the like, etc.

Examples of aliphatic diamines include, but are not limited to: alkylene diamines, such as ethylenediamine, 1,3-diaminopropane, 1,4-diaminobutane, 1,5-diaminopentane, 1,6-diaminohexane, 1,7-diaminoheptane, 1,8-diaminooctane, 1,9-diaminononane, and 1,10-diaminodecane; bis(aminomethyl) ether; bis(2-aminoethyl) ether; siloxane diamines, such as 1,3-bis(3-aminopropyl)tetramethyldisiloxane, 1,3-bis(4-aminobutyl)tetramethyldisiloxane, and α,ω-bis(3-aminopropyl)polydimethylsiloxane; etc.

Examples of polyether diamines include, but are not limited to, 1,2-bis(aminoethoxy)ethane, HK-511, ED-600, ED-900, ED-2003, EDR-148, EDR-176, D-230, D-400, D-2000, THF-100, THF-140, THF-170, RE-600, RE-900, RE-2000, RP-405, RP-409, RP-2005, RP-2009, RT-1000, HE-1000, HT-1700 (trade names, manufactured by Huntsman Corporation), etc. One of these may be used, or they may be used in mixture.

One of these aromatic diamines, alicyclic diamines, aliphatic diamines, and polyether diamines can be used, or two or more kinds thereof may be used in combination.

Siloxane diamines can also be used suitably.

Furthermore, as stated above, the inventive polymer can further contain, in addition to the structural unit represented by the general formula (1), a structural unit represented by the following general formula (5). 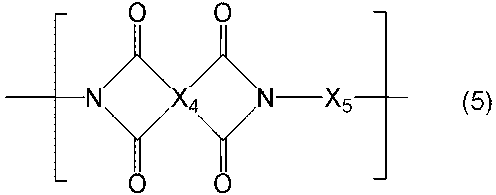 In the formula, X₄ and X₅ are as defined above.

A polymer containing the structural unit represented by the general formula (5) can be obtained by allowing a tetracarboxylic dianhydride represented by the following general formula (19) to react with a diamine represented by the following general formula (20). Firstly, a tetracarboxylic dianhydride represented by the following general formula (19) can be allowed to react with a diamine represented by the following general formula (20) to synthesize an amic acid, and then subsequently, imidization can be performed by chemical imidization or thermal dehydration to give a polymer containing the structural unit (5).

The structural unit (5) can be prepared by: dissolving a diamine represented by the following general formula (20) in a solvent that has a high boiling point and high polarity, such as γ-butyrolactone and N-methyl-2-pyrrolidone; then adding a tetracarboxylic dianhydride represented by the following general formula (19) thereto and carrying out a reaction of the resultant mixture at 0 to 80°C, preferably 10 to 50°C, to form an amic acid; and then, in the case of chemical imidization, performing a imidization reaction by adding, for example, acetic anhydride and pyridine, and in the case of imidization by thermal dehydration, adding a non-polar solvent, such as xylene, thereto and heating the reaction solution at 100 to 200°C, preferably 130 to 180°C, thereby carrying out an imidization reaction while removing water from the reaction system. 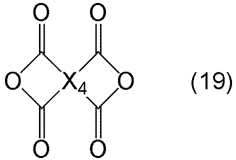 In the formula, X₄ is as defined above.

NH₂-X₅-NH₂ (20)

In the formula, X₅ is as defined above.

Suitable examples of the tetracarboxylic dianhydride represented by the general formula (19) include the examples given for the tetracarboxylic dianhydride represented by the general formula (14).

Suitable examples of the diamine represented by the general formula (20) include the examples given for the diamine represented by the general formula (17).

Furthermore, as stated above, the inventive polymer can further contain, in addition to the structural unit represented by the general formula (1), a structural unit represented by the following general formula (6). 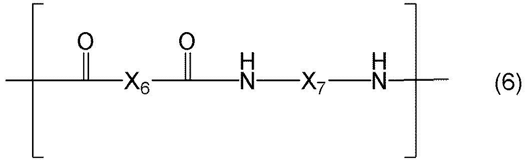 In the formula, X₆ and X₇ are as defined above.

A polymer containing the structural unit represented by the general formula (6) can be obtained by performing the same reaction procedure as in the case of the structural unit (1). That is, the polymer can be obtained by reacting a dicarboxylic acid compound represented by the following general formula (21) in the presence of a dehydration condensation agent or using a chlorinating agent to convert the compound into an acid chloride, and then reacting the acid chloride with a diamine represented by the following general formula (22) .

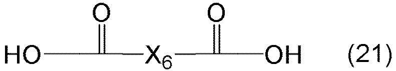

In the formula, X₆ is as defined above.

NH₂-X₇-NH₂ (22)

In the formula, X₇ is as defined above.

Examples of the dicarboxylic acid compound represented by the general formula (21) include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, diglycolic acid, etc.

Further, examples of the dicarboxylic acid compound having an aromatic ring include, but are not limited to, phthalic acid, isophthalic acid, terephthalic acid, 4,4'-diphenyl ether dicarboxylic acid, 3,4'-diphenyl ether dicarboxylic acid, 3,3'-diphenyl ether dicarboxylic acid, 4,4'-biphenyldicarboxylic acid, 3,4'-biphenyldicarboxylic acid, 3,3'-biphenyldicarboxylic acid, 4,4'-benzophenonedicarboxylic acid, 3,4'-benzophenonedicarboxylic acid, 3,3'-benzophenonedicarboxylic acid, 4,4'-hexafluoroisopropylidenedibenzoic acid, 4,4'-dicarboxydiphenylamide, 1,4-phenylenediethanoic acid, bis(4-carboxyphenyl)sulfide, 2,2-bis(4-carboxyphenyl)-1,1,1,3,3,3-hexafluoropropane, bis(4-carboxyphenyl)tetraphenyldisiloxane, bis(4-carboxyphenyl)tetramethyldisiloxane, bis(4-carboxyphenyl)sulfone, bis(4-carboxyphenyl)methane, 5-tert-butylisophthalic acid, 5-bromoisophthalic acid, 5-fluoroisophthalic acid, 5-chloroisophthalic acid, 2,2-bis-(p-carboxyphenyl)propane, and 2,6-naphthalenedicarboxylic acid, etc. In addition, one of the compounds may be used or the compounds may be used in mixture.

Suitable examples of the diamine represented by the general formula (22) include the examples given for the diamine represented by the general formula (17).

Furthermore, as stated above, the inventive polymer can further contain, in addition to the structural unit represented by the general formula (1), a structural unit represented by the following general formula (7). 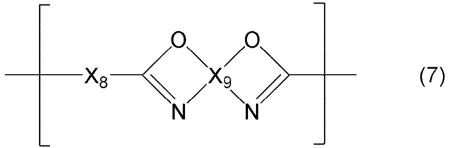 In the formula, X₈ and X₉ are as defined above.

A polymer containing the structural unit represented by the general formula (7) can be obtained by reacting a dicarboxylic acid compound represented by the following general formula (23) in the presence of a dehydration condensation agent or using a chlorinating agent to convert the compound into an acid chloride, then reacting the acid chloride with a dihydroxydiamine compound represented by the following general formula (24) to synthesize a hydroxyamide (polyoxazole precursor), and then forming an oxazole ring through a thermal dehydration process. 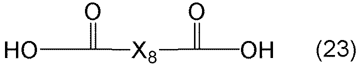 In the formula, X₈ is as defined above. 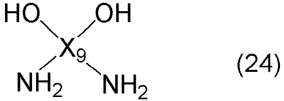 In the formula, X₉ is as defined above.

Suitable examples of the dicarboxylic acid compound represented by the general formula (23) include the examples given for the dicarboxylic acid compound represented by the general formula (21).

Examples of the dihydroxydiamine compound represented by the general formula (24) include, but are not limited to, 3,3'-diamino-4,4'-dihydroxybiphenyl, 3,3'-diamino-4,4'-dihydroxybiphenyl ether, 2,2'-bis(3-amino-4-hydroxyphenyl)sulfide, 2,2'-bis(3-amino-4-hydroxyphenyl) ketone, 3,3'-diamino-4,4'-dihydroxyphenylmethane, 1,2-bis(3-amino-4-hydroxyphenyl)ethane, 2,2'-bis(3-amino-4-hydroxyphenyl)difluoromethane, 4,4'-(1,1,2,2,3,3-hexafluoro-1,3-propanediyl)bis(2-aminophenol), 2,2'-bis(3-amino-4-hydroxyphenyl)propane, 2,2'-bis(3-amino-4-hydroxyphenyl)hexafluoropropane, 2,2'-bis(3-amino-4-hydroxyphenyl)sulfone, 1,1-bis(3-amino-4-hydroxyphenyl)cyclohexane, 4,4'-(1,4-phenylenebis(oxy))bis(2-aminophenol), 9,9-bis(3-amino-4-hydroxyphenyl)fluorene, etc. Furthermore, one of these compounds may be used, or a mixture thereof may be used.

### (Molecular Weight of Polymer and Introduction of End-Capping Agent)

A suitable molecular weight of the above-described polymer is preferably 5,000 to 100,000, more preferably 7,000 to 50,000. When the molecular weight is 5,000 or more, there are no problems in forming a film of the inventive negative photosensitive resin composition containing the above-described polymer with a desired film thickness on a substrate. When the molecular weight is 100,000 or less, the viscosity of the negative photosensitive resin composition is suitable, and there are no problems in film formation.

The above-described polymer may be capped at both ends with an end-capping agent for the purposes of controlling the molecular weight in the polycondensation reaction and preventing temporal change in the molecular weight of the obtained polymer, that is, gelation. Examples of an end-capping agent that reacts with an acid dianhydride include monoamines, monohydric alcohols, etc. In addition, examples of an end-capping agent that reacts with a diamine compound include acid anhydrides, monocarboxylic acids, monoacid chloride compounds, monoactive ester compounds, dicarbonate esters, vinyl ethers, etc. In addition, by reacting the polymer with an end-capping agent, a variety of organic groups can be introduced as end groups.

Examples of the monoamine to be used as the capping agent for the acid anhydride group terminal include, but are not limited to, aniline, 5-amino-8-hydroxyquinoline, 4-amino-8-hydroxyquinoline, 1-hydroxy-8-aminonaphthalene, 1-hydroxy-7-aminonaphthalene, 1-hydroxy-6-aminonaphthalene, 1-hydroxy-5-aminonaphthalene, 1-hydroxy-4-aminonaphthalene, 1-hydroxy-3-aminonaphthalene, 1-hydroxy-2-aminonaphthalene, 1-amino-7-hydroxynaphthalene, 2-hydroxy-7-aminonaphthalene, 2-hydroxy-6-aminonaphthalene, 2-hydroxy-5-aminonaphthalene, 2-hydroxy-4-aminonaphthalene, 2-hydroxy-3-aminonaphthalene, 1-amino-2-hydroxynaphthalene, 1-carboxy-8-aminonaphthalene, 1-carboxy-7-aminonaphthalene, 1-carboxy-6-aminonaphthalene, 1-carboxy-5-aminonaphthalene, 1-carboxy-4-aminonaphthalene, 1-carboxy-3-aminonaphthalene, 1-carboxy-2-aminonaphthalene, 1-amino-7-carboxynaphthalene, 2-carboxy-7-aminonaphthalene, 2-carboxy-6-aminonaphthalene, 2-carboxy-5-aminonaphthalene, 2-carboxy-4-aminonaphthalene, 2-carboxy-3-aminonaphthalene, 1-amino-2-carboxynaphthalene, 2-aminonicotinic acid, 4-aminonicotinic acid, 5-aminonicotinic acid, 6-aminonicotinic acid, 4-aminosalicylic acid, 5-aminosalicylic acid, 6-aminosalicylic acid, ammelide, 2-aminobenzoic acid, 3-aminobenzoic acid, 4-aminobenzoic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 5-amino-8-mercaptoquinoline, 4-amino-8-mercaptoquinoline, 1-mercapto-8-aminonaphthalene, 1-mercapto-7-aminonaphthalene, 1-mercapto-6-aminonaphthalene, 1-mercapto-5-aminonaphthalene, 1-mercapto-4-aminonaphthalene, 1-mercapto-3-aminonaphthalene, 1-mercapto-2-aminonaphthalene, 1-amino-7-mercaptonaphthalene, 2-mercapto-7-aminonaphthalene, 2-mercapto-6-aminonaphthalene, 2-mercapto-5-aminonaphthalene, 2-mercapto-4-aminonaphthalene, 2-mercapto-3-aminonaphthalene, 1-amino-2-mercaptonaphthalene, 3-amino-4,6-dimercaptopyrimidine, 2-aminothiophenol, 3-aminothiophenol, 4-aminothiophenol, 2-ethynylaniline, 3-ethynylaniline, 4-ethynylaniline, 2,4-diethynylaniline, 2,5-diethynylaniline, 2,6-diethynylaniline, 3,4-diethynylaniline, 3,5-diethynylaniline, 1-ethynyl-2-aminonaphthalene, 1-ethynyl-3-aminonaphthalene, 1-ethynyl-4-aminonaphthalene, 1-ethynyl-5-aminonaphthalene, 1-ethynyl-6-aminonaphthalene, 1-ethynyl-7-aminonaphthalene, 1-ethynyl-8-aminonaphthalene, 2-ethynyl-1-aminonaphthalene, 2-ethynyl-3-aminonaphthalene, 2-ethynyl-4-aminonaphthalene, 2-ethynyl-5-aminonaphthalene, 2-ethynyl-6-aminonaphthalene, 2-ethynyl-7-aminonaphthalene, 2-ethynyl-8-aminonaphthalene, 3,5-diethynyl-1-aminonaphthalene, 3,5-diethynyl-2-aminonaphthalene, 3,6-diethynyl-1-aminonaphthalene, 3,6-diethynyl-2-aminonaphthalene, 3,7-diethynyl-1-aminonaphthalene, 3,7-diethynyl-2-aminonaphthalene, 4,8-diethynyl-1-aminonaphthalene, 4,8-diethynyl-2-aminonaphthalene, 4-fluoroaniline, 3-fluoroaniline, 2-fluoroaniline, 2,4-difluoroaniline, 3,4-difluoroaniline, 2,4,6-trifluoroaniline, 2,3,4-trifluoroaniline, pentafluoroaniline, etc. One of these monoamines may be used, or two or more thereof may be used in combination.

Meanwhile, examples of the monohydric alcohol to be used as the capping agent for the acid anhydride group terminal include, but are not limited to, methanol, ethanol, 1-propanol, 2-propanol, 1-butanol, 2-butanol, 1-pentanol, 2-pentanol, 3-pentanol, 1-hexanol, 2-hexanol, 3-hexanol, 1-heptanol, 2-heptanol, 3-heptanol, 1-octanol, 2-octanol, 3-octanol, 1-nonanol, 2-nonanol, 1-decanol, 2-decanol, 1-undecanol, 2-undecanol, 1-dodecanol, 2-dodecanol, 1-tridecanol, 2-tridecanol, 1-tetradecanol, 2-tetradecanol, 1-pentadecanol, 2-pentadecanol, 1-hexadecanol, 2-hexadecanol, 1-heptadecanol, 2-heptadecanol, 1-octadecanol, 2-octadecanol, 1-nonadecanol, 2-nonadecanol, 1-icosanol, 2-methyl-1-propanol, 2-methyl-2-propanol, 2-methyl-1-butanol, 3-methyl-1-butanol, 2-methyl-2-butanol, 3-methyl-2-butanol, 2-propyl-1-pentanol, 2-ethyl-1-hexanol, 4-methyl-3-heptanol, 6-methyl-2-heptanol, 2,4,4-trimethyl-1-hexanol, 2,6-dimethyl-4-heptanol, isononyl alcohol, 3,7-dimethyl-3-octanol, 2,4-dimethyl-1-heptanol, 2-heptylundecanol, ethylene glycol monoethyl ether, ethylene glycol monomethyl ether, ethylene glycol monobutyl ether, propylene glycol 1-methyl ether, diethylene glycol monoethyl ether, diethylene glycol monomethyl ether, diethylene glycol monobutyl ether, cyclopentanol, cyclohexanol, cyclopentanemonomethylol, dicyclopentanemonomethylol, tricyclodecanemonomethylol, norborneol, terpineol, etc. One of these may be used, or two or more thereof may be used in combination.

Examples of the acid anhydride, monocarboxylic acid, monoacid chloride compound and monoactive ester compound to be used as the capping agent for the amino group terminal include acid anhydrides, such as phthalic anhydride, maleic anhydride, nadic anhydride, cyclohexanedicarboxylic anhydride and 3-hydroxyphthalic anhydride; monocarboxylic acids, such as 2-carboxyphenol, 3-carboxyphenol, 4-carboxyphenol, 2-carboxythiophenol, 3-carboxythiophenol, 4-carboxythiophenol, 1-hydroxy-8-carboxynaphthalene, 1-hydroxy-7-carboxynaphthalene, 1-hydroxy-6-carboxynaphthalene, 1-hydroxy-5-carboxynaphthalene, 1-hydroxy-4-carboxynaphthalene, 1-hydroxy-3-carboxynaphthalene, 1-hydroxy-2-carboxynaphthalene, 1-mercapto-8-carboxynaphthalene, 1-mercapto-7-carboxynaphthalene, 1-mercapto-6-carboxynaphthalene, 1-mercapto-5-carboxynaphthalene, 1-mercapto-4-carboxynaphthalene, 1-mercapto-3-carboxynaphthalene, 1-mercapto-2-carboxynaphthalene, 2-carboxybenzenesulfonic acid, 3-carboxybenzenesulfonic acid, 4-carboxybenzenesulfonic acid, 2-ethynylbenzoic acid, 3-ethynylbenzoic acid, 4-ethynylbenzoic acid, 2,4-diethynylbenzoic acid, 2,5-diethynylbenzoic acid, 2,6-diethynylbenzoic acid, 3,4-diethynylbenzoic acid, 3,5-diethynylbenzoic acid, 2-ethynyl-1-naphthoic acid, 3-ethynyl-1-naphthoic acid, 4-ethynyl-1-naphthoic acid, 5-ethynyl-1-naphthoic acid, 6-ethynyl-1-naphthoic acid, 7-ethynyl-1-naphthoic acid, 8-ethynyl-1-naphthoic acid, 2-ethynyl-2-naphthoic acid, 3-ethynyl-2-naphthoic acid, 4-ethynyl-2-naphthoic acid, 5-ethynyl-2-naphthoic acid, 6-ethynyl-2-naphthoic acid, 7-ethynyl-2-naphthoic acid and 8-ethynyl-2-naphthoic acid, and monoacid chloride compounds in which the carboxy group of the above monocarboxylic acids is acid-chlorinated; monoacid chloride compounds of dicarboxylic acids, such as terephthalic acid, phthalic acid, maleic acid, cyclohexanedicarboxylic acid, 3-hydroxyphthalic acid, 5-norbornene-2,3-dicarboxylic acid, 1,2-dicarboxynaphthalene, 1,3-dicarboxynaphthalene, 1,4-dicarboxynaphthalene, 1,5-dicarboxynaphthalene, 1,6-dicarboxynaphthalene, 1,7-dicarboxynaphthalene, 1,8-dicarboxynaphthalene, 2,3-dicarboxynaphthalene, 2,6-dicarboxynaphthalene and 2,7-dicarboxynaphthalene, in which only a monocarboxy group is acid-chlorinated; and monoactive ester compounds obtained through reaction between monoacid chloride compounds and N-hydroxybenzotriazole or N-hydroxy-5-norbornene-2,3-dicarboxyimide.

Examples of the dicarbonate ester compound to be used as the capping agent for the amino group terminal include di-tert-butyl dicarbonate, dibenzyl dicarbonate, dimethyl dicarbonate, diethyl dicarbonate, etc.

Examples of the vinyl ether compound to be used as the capping agent for the amino group terminal include butyl vinyl ether, cyclohexyl vinyl ether, ethyl vinyl ether, 2-ethylhexyl vinyl ether, isobutyl vinyl ether, isopropyl vinyl ether, n-propyl vinyl ether, tert-butyl vinyl ether, benzyl vinyl ether, etc.

Examples of another compound to be used as the capping agent for the amino group terminal include benzoyl chloride; chloroformate esters, such as fluorenylmethyl chloroformate, 2,2,2-trichloroethyl chloroformate, tert-butyl chloroformate, n-butyl chloroformate, isobutyl chloroformate, benzyl chloroformate, allyl chloroformate, ethyl chloroformate, and isopropyl chloroformate; isocyanate compounds, such as butyl isocyanate, 1-naphthyl isocyanate, octadecyl isocyanate, and phenyl isocyanate; methanesulfonic acid chloride and p-toluenesulfonic acid chloride; etc.

The proportion of the capping agent to be introduced for the acid anhydride group terminal is preferably in the range of 0.1 to 60 mol%, particularly preferably 5 to 50 mol%, and further preferably 5 to 20 mol% relative to the total amount of the tetracarboxylic dianhydride component and the dicarboxylic acid component. Moreover, the proportion of the capping agent to be introduced for the amino group terminal is preferably in the range of 0.1 to 100 mol% and particularly preferably 5 to 90 mol% relative to the diamine component. Moreover, by allowing a reaction with a plurality of end-capping agents, a plurality of different end groups may be introduced.

### [Negative Photosensitive Resin Composition]

Next, a photosensitive resin composition containing the inventive polymer having the polyimide precursor as a base resin will be described. In the present invention, by using the above-described inventive polymer having the polyimide precursor as a base resin, a negative photosensitive resin composition can be obtained. In the following, a photosensitive resin composition containing the inventive polymer having the polyimide precursor as a base resin, specifically, a negative photosensitive resin composition with which a negative pattern can be formed and which can be developed with an organic solvent will be described, but the composition is not limited thereto.

The inventive negative photosensitive resin composition contains:
(A) a polymer having a polyimide precursor containing a structural unit represented by the general formula (1);
(B) a photo-radical initiator; and
(E) a solvent.

The component (A) in the inventive negative photosensitive resin composition is a polymer having a polyimide precursor containing a structural unit represented by the general formula (1) (that is, a polymer containing the structural unit (1)). This polymer has a polymerizable unsaturated bond group in the molecule, and therefore, a negative photosensitive resin composition can be obtained by the combination of the polymer and the photo-radical initiator.

The component (B) in the inventive negative photosensitive resin composition is a photo-radical initiator. As the photo-radical initiator, any compound that is conventionally used as a photopolymerization initiator for UV curing can be selected. Preferable examples of the photo-radical initiator include, but are not limited to: benzophenone derivatives, such as benzophenone, methyl o-benzoylbenzoate, 4-benzoyl-4'-methyldiphenyl ketone, dibenzyl ketone, and fluorenone; acetophenone derivatives, such as 2,2'-diethoxyacetophenone, 2-hydroxy-2-methylpropiophenone, and 1-hydroxycyclohexyl phenyl ketone; thioxanthone derivatives, such as thioxanthone, 2-methylthioxanthone, 2-isopropylthioxanthone, and diethylthioxanthone; benzyl derivatives, such as benzyl, benzyl dimethyl ketal, and benzyl-β-methoxyethyl acetal; benzoin derivatives, such as benzoin and benzoin methyl ether; oximes, such as 1-phenyl-1,2-butanedione-2-(O-methoxycarbonyl)oxime, 1-phenyl-1,2-propanedione-2-(O-methoxycarbonyl)oxime, 1-phenyl-1,2-propanedione-2-(O-ethoxycarbonyl)oxime, 1-phenyl-1,2-propanedione-2-(O-benzoyl)oxime, 1,3-diphenylpropanetrione-2-(O-ethoxycarbonyl)oxime, and 1-phenyl-3-ethoxypropanetrione-2-(O-benzoyl)oxime; N-arylglycines, such as N-phenylglycine; peroxides, such as benzoyl perchloride; and aromatic biimidazoles. Furthermore, one of these compounds may be used, or two or more kinds thereof may be used in mixture. Among the above photo-radical initiators, oximes are more preferable particularly from the viewpoint of photosensitivity.

The component (B) is preferably contained in an amount of 0.1 parts by mass to 20 parts by mass, and from the viewpoint of photosensitivity property, more preferably 2 parts by mass to 15 parts by mass relative to 100 parts by mass of the component (A), being the inventive polymer having the polyimide precursor. When the component (B) is contained in an amount of 0.1 parts by mass or more relative to 100 parts by mass of the component (A), the obtained negative photosensitive resin composition is excellent in photosensitivity, and meanwhile, when contained in an amount of 20 parts by mass or less, the obtained negative photosensitive resin composition is excellent in thick-film curability.

Next, the component (E) in the inventive negative photosensitive resin composition is a solvent. The solvent of the component (E) is not limited as long as it is capable of dissolving the components (A) and (B). Examples of the solvent include: ketones, such as cyclohexanone, cyclopentanone, and methyl-2-n-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, and γ-butyrolactone; and amide-based solvents such as N-methyl-2-pyrrolidone, N,N-dimethylacetamide, 3-methoxy-N,N-dimethylpropanamide, and N,N-dimethylformamide. One or more kinds thereof may be used. In particular, ethyl lactate, cyclohexanone, cyclopentanone, propylene glycol monomethyl ether acetate, γ-butyrolactone, N-methyl-2-pyrrolidone, or a mixed solvent thereof is preferable.

The amount of the component (E) to be contained is preferably 50 to 2,000 parts by mass, particularly preferably 100 to 1,000 parts by mass based on a total of 100 parts by mass of the contained amount of the components (A) and (B).

The inventive negative photosensitive resin composition can further contain, as a component (C):
(C) a crosslinking agent having two or more photopolymerizable unsaturated bond groups in one molecule.

When a crosslinking agent having two or more photopolymerizable unsaturated bonds in one molecule is contained as described, it is possible to promote the crosslinking by the photopolymerization of the component (A) in exposed portions and enhance the contrast between exposed and unexposed portions.

The component (C) of the inventive negative photosensitive resin composition is a crosslinking agent having two or more photopolymerizable unsaturated bond groups per molecule. As the crosslinking agent having two or more photopolymerizable unsaturated bond groups per molecule, (meth)acrylic compounds are preferable, and preferable examples include, but are not limited to, ethylene glycol diacrylate, ethylene glycol dimethacrylate, polyethylene glycol diacrylate (each having 2 to 20 ethylene glycol units), polyethylene glycol dimethacrylate (each having 2 to 20 ethylene glycol units), poly(1,2-propylene glycol) diacrylate, poly(1,2-propylene glycol) dimethacrylate, 1,6-hexanediol diacrylate, neopentyl glycol diacrylate, pentaerythritol diacrylate, trimethylolpropane triacrylate, pentaerythritol triacrylate, dipentaerythritol hexaacrylate, tetramethylolpropane tetraacrylate, tetraethylene glycol diacrylate, 1,6-hexanediol dimethacrylate, neopentyl glycol dimethacrylate, pentaerythritol dimethacrylate, trimethylolpropane trimethacrylate, pentaerythritol trimethacrylate, dipentaerythritol hexamethacrylate, tetramethylolpropane tetramethacrylate, glycerol diacrylate, glycerol dimethacrylate, methylenebisacrylamide, N-methylolacrylamide, an adduct of ethylene glycol diglycidyl ether and methacrylic acid, an adduct of glycerol diglycidyl ether and acrylic acid, an adduct of bisphenol A diglycidyl ether and acrylic acid, an adduct of bisphenol A diglycidyl ether-methacrylic acid, and N,N'-bis(2-methacryloyloxyethyl) urea.

The component (C) is preferably contained in an amount of 1 to 100 parts by mass, further preferably 3 to 50 parts by mass based on 100 parts by mass of the component (A). When the amount is in the range of 1 to 100 parts by mass, the target effect can be achieved sufficiently, and there are no undesirable effects on developing properties. Note that, as a copolymerization monomer, one kind of compound may be used, or a mixture of multiple kinds may be used.

The inventive negative photosensitive resin composition can further contain, as a component (D) a heat crosslinking agent, one or more kinds of crosslinking agents selected from an amino condensate modified with formaldehyde or formaldehyde-alcohol; a phenol compound having two or more methylol groups or alkoxymethylol groups on average in one molecule; a compound in which a hydrogen atom of a hydroxy group of a polyhydric phenol is substituted with a glycidyl group; a compound in which a hydrogen atom of a hydroxy group of a polyhydric phenol or a hydroxy group of a polyhydric alcohol is substituted with a substituent represented by the following formula (D-1); and a compound having two or more nitrogen atoms each having a glycidyl group represented by the following formula (D-2). 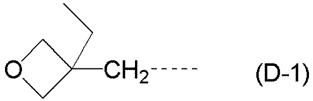 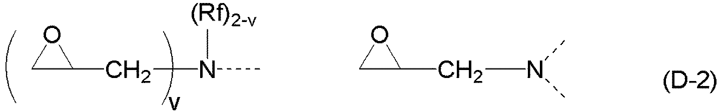 In the formulae, a dotted line represents an attachment point, Rf represents a linear, branched, or cyclic alkyl group having 1 to 6 carbon atoms, and "v" represents 1 or 2.

Examples of the amino condensates modified by the formaldehyde or formaldehyde-alcohol include a melamine condensate modified by the formaldehyde or formaldehyde-alcohol, and a urea condensate modified by the formaldehyde or formaldehyde-alcohol.

The melamine condensate modified by the formaldehyde or formaldehyde-alcohol is prepared, for example, in such a manner that, firstly, according to a well-known method, a melamine monomer is modified by methylol reaction with formalin, or this is further modified by alkoxylation with alcohol, and thus, a modified melamine represented by the following general formula (25) is obtained. As the alcohol, a lower alcohol, for example, an alcohol having 1 to 4 carbon atoms, is preferable. 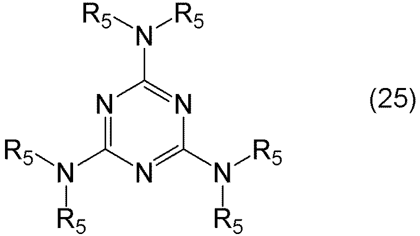 In the formula, R₅s may be the identical to or different from each other, and are methylol groups, alkoxymethyl groups containing an alkoxy group having 1 to 4 carbon atoms, or hydrogen atoms, provided that at least one R₅ is a methylol group or the alkoxymethyl group.

Examples of the R₅ include a hydrogen atom, a methylol group, and alkoxymethyl groups such as a methoxymethyl group and an ethoxymethyl group.

Specific examples of the modified melamine represented by the general formula (25) include trimethoxymethylmonomethylol melamine, dimethoxymethylmonomethylol melamine, trimethylol melamine, hexamethylol melamine, and hexamethoxymethylol melamine. Next, the modified melamine represented by the general formula (25) or its multimer (for example, an oligomer such as a dimer or a trimer) is subjected to addition condensation polymerization with formaldehyde until a desired molecular weight is obtained according to the conventional method to obtain a melamine condensate modified by formaldehyde or formaldehyde-alcohol.

The urea condensate modified by the formaldehyde or formaldehyde-alcohol is prepared, according to, for example, a well-known method, by modifying a urea condensate having a desired molecular weight by methylol reaction with formaldehyde, or by further modifying by alkoxylation with alcohol.

Specific examples of the urea condensate modified by the formaldehyde or formaldehyde-alcohol include a methoxymethylated urea condensate, an ethoxymethylated urea condensate, a propoxymethylated urea condensate, and the like.

One of these modified melamine condensates and modified urea condensates may be used or two or more kinds thereof may be used in mixture.

Next, examples of the phenol compound having two or more methylol groups or alkoxymethylol groups in average in one molecule include (2-hydroxy-5-methyl)-1,3-benzenedimethanol, 2,2',6,6'-tetramethoxymethylbisphenol A, compounds represented by the following formulae (D-3) to (D-8), and the like.

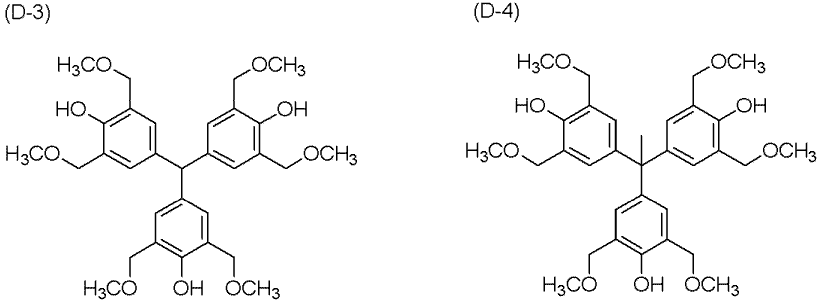

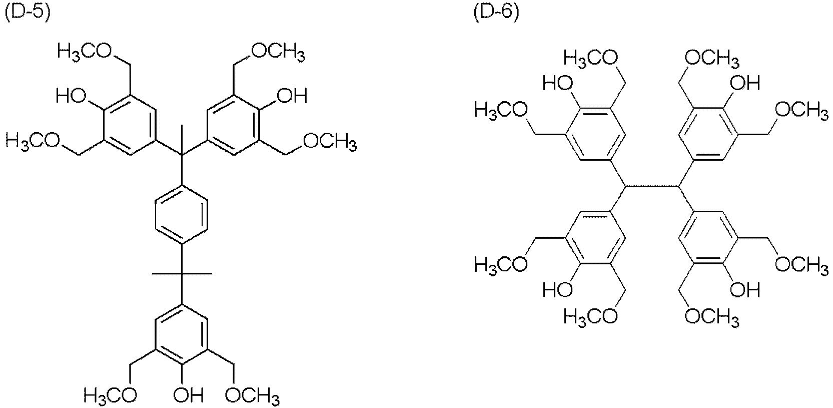

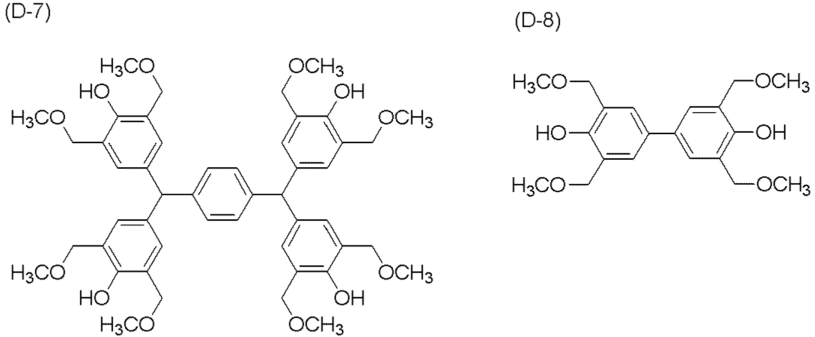

One of the crosslinking agents may be used or two or more kinds may be used in combination.

Meanwhile, examples of the compounds in which a hydrogen atom of a hydroxy group of polyhydric phenol is substituted with a glycidyl group include a compound obtained by reaction of the hydroxy group of bisphenol A, tris(4-hydroxyphenyl)methane, and 1,1,1-tris(4-hydroxyphenyl)ethane with epichlorohydrin in the presence of a base. Suitable examples of the compound in which a hydrogen atom of a hydroxy group of a polyhydric phenol is substituted with a glycidyl group include the compounds represented by the following formulae (D-9) to (D-15). 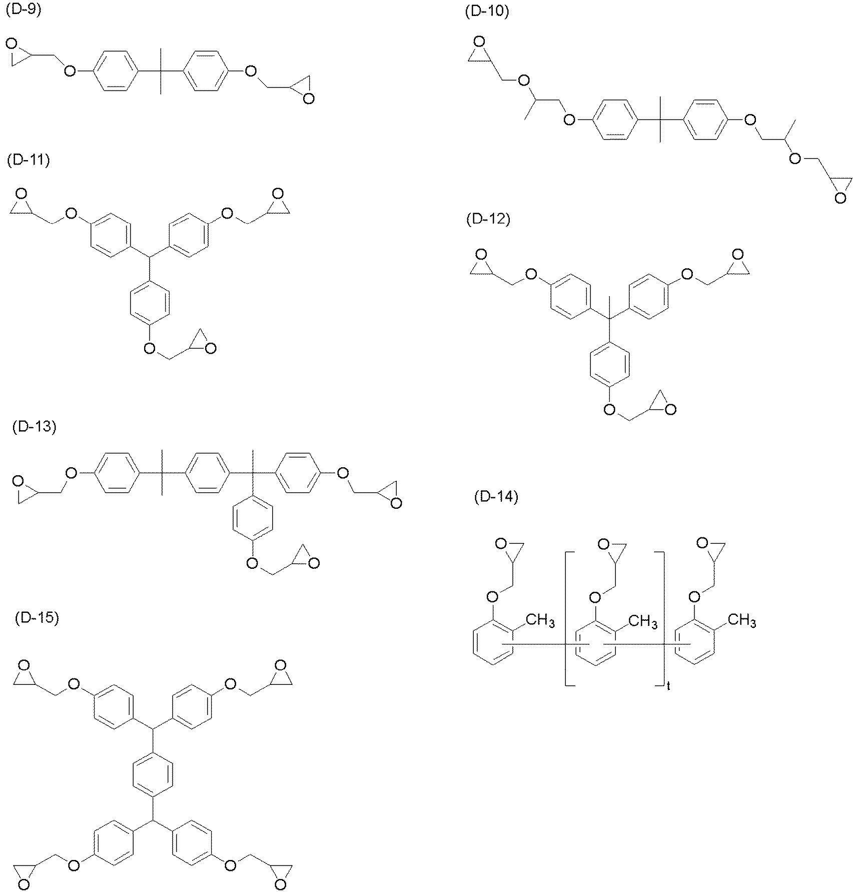 In the formulae, "t" satisfies 2 ≤ t ≤ 3.

Furthermore, preferable examples of compounds other than those of the formulae (D-9) to (D-15) include EPICLON 850-S, EPICLON HP-4032, EPICLON HP-7200, EPICLON HP-820, EPICLON HP-4700, EPICLON EXA-4710, EPICLON HP-4770, EPICLON EXA-859CRP, EPICLON EXA-4880, EPICLON EXA-4850, EPICLON EXA-4816, EPICLON EXA-4822 (all trade names, manufactured by DIC Corporation), RIKARESIN BPO-20E, RIKARESIN BEO-60E (both trade names, manufactured by New Japan Chemical Co., Ltd.), EP-4003S, EP-4000S, EP-4000S, EP-4000L (all trade names, manufactured by ADEKA CORPORATION), jER828EL, YX7105 (both trade names, manufactured by Mitsubishi Chemical Group Corporation), etc.

One kind or two kinds of the compounds obtained by substituting a hydroxy group of the polyhydric phenol with a glycidoxy group (a compound in which a hydrogen atom of a hydroxy group of polyhydric phenol is substituted with a glycidyl group) may be used as a crosslinking agent.

Examples of the compound in which a hydrogen atom of a hydroxy group of polyhydric phenol is substituted with a substituent represented by the following formula (D-1) include ones containing two or more of the substituents and represented by the following formula (D-16). 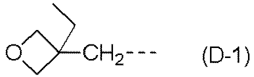 In the formula, a dotted line represents an attachment point. 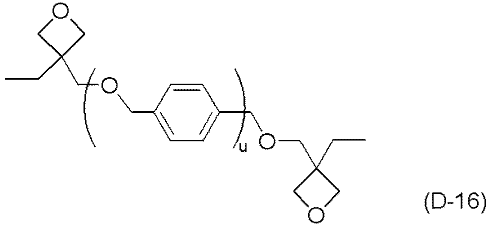 In the formula, 1 ≤ u ≤ 3.

Furthermore, preferable examples of compounds other than those of the formulae (D-9) to (D-15) include 3-ethyl-3-hydroxymethyloxetane, 1,4-bis{[(3-ethyl-3-oxethanyl)methoxy]methyl}benzene, 3-ethyl-3-(2-ethylhexylmethyl)oxetane, 1,4-benzendicarboxylic acid bis[(3-ethyl-3-oxetanyl)methyl] ester, ARON OXETANE series manufactured by TOAGOSEI CO., LTD., etc.

Meanwhile, examples of the compound containing two or more nitrogen atoms having a glycidyl group represented by the following formulae (D-2) include ones represented by the following formula (D-17). 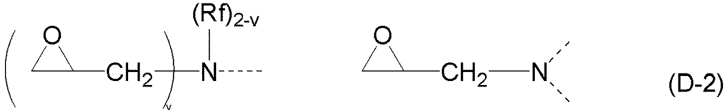 In the formulae, a dotted line represents an attachment point, Rf represents a linear, branched, or cyclic alkyl group having 1 to 6 carbon atoms, and "v" represents 1 or 2. 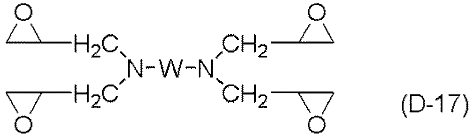 In the formula, W represents a linear, branched, or cyclic alkylene group having 2 to 12 carbon atoms or a divalent aromatic group. Note that this W applies only in the above formula.

Examples of the compounds represented by the formula (D-17) include compounds represented by the following formulae (D-18) to (D-21).

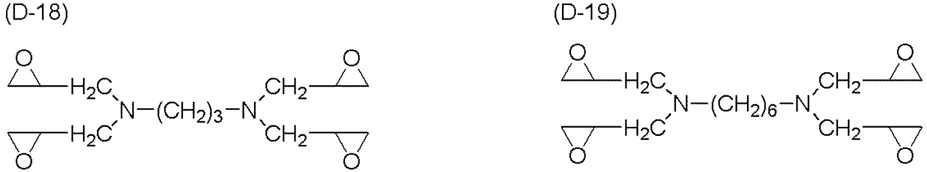

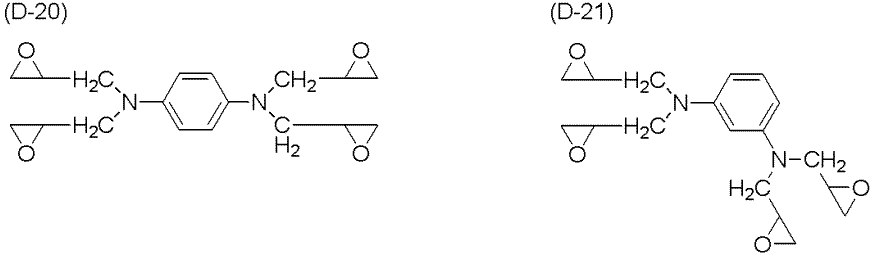

Meanwhile, as the compound containing two or more nitrogen atoms each of which has a glycidyl group(s) represented by the formula (D-2), compounds represented by the following formulae (D-22) and (D-23) may be suitably used.

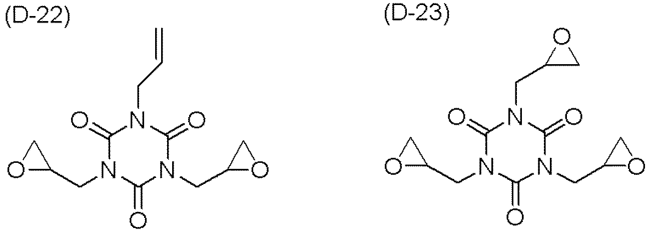

One kind or two kinds of these compounds containing two or more nitrogen atoms each of which has a glycidyl group(s) represented by the formula (D-2) may be used as a crosslinking agent.

An epoxy group is greatly distorted in the ring and has high reactivity, and oxetane has high basicity and easily bonds with an acid. It is reported that by combining oxetanyl groups with epoxy groups, the reactivity in cation polymerization improves remarkably.

The component (D) is a component that causes a crosslinking reaction in the post-curing after forming a pattern of the inventive negative photosensitive resin composition to further increase the strength of a cured product. A weight-average molecular weight of such a component (D) is preferably 150 to 10,000, and particularly preferably 200 to 3,000, from the viewpoint of the photocurability and heat resistance.

In the inventive negative photosensitive resin composition, the amount of the component (D) to be contained is preferably 0.5 to 100 parts by mass, particularly preferably 1 to 80 parts by mass relative to 100 parts by mass of the component (A).

In addition, the inventive negative photosensitive resin composition may further contain, in addition to the components (A), (B), (C), (D), and (E), one or more selected from (F) a protective amine compound, (G) a thermal acid generator, (H) an antioxidant, and (I) a silane compound.

The inventive negative photosensitive resin composition can further contain (F) a protective amine compound in addition to the components (A), (B), (C), (D), and (E). The component (F) protective amine compound can be any protective amine compound, as long as it is a nitrogen-containing organic compound in which a group that is deprotected by heat or an acid is bonded to a nitrogen atom. In particular, the protective amine compound is not particularly limited as long as it has a carbamate structure represented by the following general formula (26) or (27). 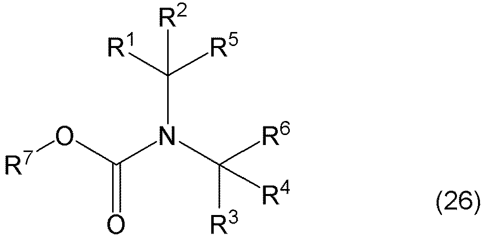 Here, in the formula, R¹, R², R³, and R⁴ each independently represent hydrogen, an alkyl group having 1 to 8 carbon atoms optionally having a substituent, a cycloalkyl group having 3 to 8 carbon atoms optionally having a substituent, an alkoxyl group having 1 to 8 carbon atoms optionally having a substituent, an alkenyl group having 2 to 8 carbon atoms optionally having a substituent, an alkynyl group having 2 to 8 carbon atoms optionally having a substituent, an aryl group optionally having a substituent, or a heterocyclic group optionally having a substituent. R⁵ and R⁶ each independently represent hydrogen, an alkyl group having 1 to 8 carbon atoms optionally having a substituent, a cycloalkyl group having 3 to 8 carbon atoms optionally having a substituent, an alkoxyl group having 1 to 8 carbon atoms optionally having a substituent, an alkenyl group having 2 to 8 carbon atoms optionally having a substituent, an alkynyl group having 2 to 8 carbon atoms optionally having a substituent, an aryl group optionally having a substituent, a heterocyclic group optionally having a substituent, a single ring optionally having a substituent formed by bonding with each other, or a polycycle optionally having a substituent formed by bonding with each other. Here, the total number of carbon atoms in the formula is 10 or less.

Meanwhile, R⁷ represents an alkyl group having 1 to 12 carbon atoms optionally having a substituent, a cycloalkyl group having 3 to 12 carbon atoms optionally having a substituent, an alkenyl group having 2 to 12 carbon atoms optionally having a substituent, an alkynyl group having 2 to 12 carbon atoms optionally having a substituent, an aryl group optionally having, as a substituent, an alkyl group having 1 to 3 carbon atoms, an aralkyl group optionally having, as a substituent, an alkyl group having 1 to 3 carbon atoms, or a heterocyclic group optionally having a substituent. Here, the total number of carbon atoms constituting R⁷ is 12 or less. Any substituent may be used as the substituent that the above groups optionally have as long as it does not conflict with the intensions of the present invention.

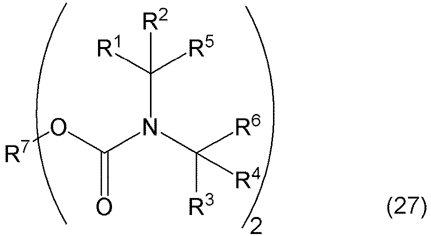

Specific examples of the formulae (26) and (27) include the following: N-(isopropoxycarbonyl)-2,6-dimethylpiperidine, N-(isopropoxycarbonyl)-2,2,6,6-tetramethylpiperidine, N-(isopropoxycarbonyl)diisopropylamine, N-(isopropoxycarbonyl)pyrrolidine, N-(isopropoxycarbonyl)-2,5-dimethylpyrrolidine, N-(isopropoxycarbonyl)-azetidine, N-(1-ethylpropoxycarbonyl)-2,6-dimethylpiperidine, N-(1-ethylpropoxycarbonyl)-2,2,6,6-tetramethylpiperidine, N-(1-ethylpropoxycarbonyl)diisopropylamine, N-(1-ethylpropoxycarbonyl)pyrrolidine, N-(1-ethylpropoxycarbonyl)-2,5-dimethylpyrrolidine, N-(1-ethylpropoxycarbonyl)-azetidine, N-(1-propylbutoxycarbonyl)-2,6-dimethylpiperidine, N-(1-propylbutoxycarbonyl)-2,2,6,6-tetramethylpiperidine, N-(1-propylbutoxycarbonyl)diisopropylamine, N-(1-propylbutoxycarbonyl)pyrrolidine, N-(1-propylbutoxycarbonyl)-2,5-dimethylpyrrolidine, N-(1-propylbutoxycarbonyl)-azetidine, N-(cyclopentoxycarbonyl)-2,6-dimethylpiperidine, N-(cyclopentoxycarbonyl)-2,2,6,6-tetramethylpiperidine, N-(cyclopentoxycarbonyl)diisopropylamine, N-(cyclopentoxycarbonyl)pyrrolidine, N-(cyclopentoxycarbonyl)-2,5-dimethylpyrrolidine, N-(cyclopentoxycarbonyl)-azetidine, N-(cyclohexylcarbonyl)-2,6-dimethylpiperidine, N-(cyclohexylcarbonyl)-2,2,6,6-tetramethylpiperidine, N-(cyclohexylcarbonyl)diisopropylamine, N-(cyclohexylcarbonyl)pyrrolidine, N-(cyclohexylcarbonyl)-2,5-dimethylpyrrolidine, N-(cyclohexylcarbonyl)-azetidine, N-(tert-butoxycarbonyl)-2,6-dimethylpiperidine, N-(tert-butoxycarbonyl)-2,2,6,6-tetramethylpiperidine, N-(tert-butoxycarbonyl)diisopropylamine, N-(tert-butoxycarbonyl)pyrrolidine, N-(tert-butoxycarbonyl)-2,5-dimethylpyrrolidine, N-(tert-butoxycarbonyl)-azetidine, N-(benzyloxycarbonyl)-2,6-dimethylpiperidine, N-(benzyloxycarbonyl)-2,2,6,6-tetramethylpiperidine, N-(benzyloxycarbonyl)diisopropylamine, N-(benzyloxycarbonyl)pyrrolidine, N-(benzyloxycarbonyl)-2,5-dimethylpyrrolidine, N-(benzyloxycarbonyl)-azetidine, 1,4-bis(N,N'-diisopropylaminocarbonyloxy)cyclohexane, imidazole compounds disclosed in JP 5609815 B, and the like.

The protective amine compound according to the present embodiment is particularly preferably decomposed 100% at 200°C or lower. In this manner, a basic compound can be generated more efficiently to promote imidization of a polyimide precursor or to promote the crosslinking reaction between a heat crosslinking agent and a resin. A base obtained by heating the protective amine compound and other decomposed products preferably have a boiling point of 200°C or lower under 1 atmosphere (0.1 GPa). This is because the decomposed product can be volatilized in a low-temperature process from during coating when the boiling point is 200°C or lower. The lower limit of the boiling point of the decomposed product under 1 atmosphere is not particularly limited, but is preferably -150°C or higher from the viewpoint of synthesizing the protective amine compound simply and conveniently.

When an amine compound is added directly to the inventive photosensitive resin composition, there is concern that the component (D) crosslinking agent and the amine compound react under room temperature and the composition becomes viscous over time so that storage stability becomes degraded. On the other hand, with an amine compound whose basic site is protected by a protecting group, the component (D) does not react under room temperature, in the same manner as when unheated. Therefore, storage stability of the photosensitive resin composition over time can be raised. In addition, since a base is only generated once heated, such an amine compound becomes a catalyst in an imide ring-closing reaction or a reaction between the component (A) polymer and the component (D) crosslinking agent, so that a crosslinking reaction can be promoted effectively.

One kind of the protective amine compound can be used or a combination of two or more kinds can be used. When 0 to 10 parts by mass of the protective amine compound is to be blended relative to 100 parts by mass of the component (A) polymer, a protective amine compound is preferably mixed in a blending amount of 0.01 to 10 parts by mass, in particular, 0.01 to 5 parts by mass. If the blending amount exceeds 10 parts by mass, the solubility of the composition is reduced, so that lithography patterning property is degraded.

The inventive negative photosensitive resin composition can further contain (G) a thermal acid generator, in addition to the components (A), (B), (C), (D), and (E). The component (G), the compound that generates an acid by heat, can be added for the purpose of thermally promoting imide ring closure or the crosslinking reaction between the components (A) and (D) in the step of heating and post-curing the composition at a temperature of 100 to 300°C performed after the patterning.

Particularly, as the component (G), preferable are those that do not promote curing of the film before a pattern is formed by development and do not inhibit the patterning. In order to accomplish this, the component (G) preferably does not generate an acid at a temperature of the step of removing the solvent and drying the film after the application of the photosensitive resin composition, but generates an acid only by heat treatment after the patterning to thereby promote curing of the pattern and film of the negative photosensitive resin composition. Specifically, the component (G) is preferably a compound that is decomposed and generates an acid through a heat treatment at 100°C to 300°C, preferably 150°C to 300°C. When such component (G) is contained, the pattern and film of the negative photosensitive resin composition can be changed to a state where crosslinking and curing reaction are more advanced in the step of heating and post-curing at a temperature of 100 to 300°C performed after the patterning. The component (G) can even further improve the mechanical strength, chemical resistance, adhesiveness, and the like of the obtained pattern or film by even further advancing crosslinking and curing reaction.

A suitable compound that generates an acid by heat is not particularly limited. For example, compounds described in paragraphs [0061] to [0085] of JP 2007-199653 A can be used.

The compound that generates an acid by heat is blended in an amount of preferably 0.1 parts by mass or more, more preferably 0.5 parts by mass or more, and preferably 30 parts by mass or less, more preferably 10 parts by mass or less, relative to 100 parts by mass of the component (A) polymer in the inventive negative photosensitive resin composition.

The inventive negative photosensitive resin composition can further contain (H) an antioxidant, in addition to the components (A), (B), (C), (D), and (E). By the component (H) antioxidant being contained, it is possible to suppress unnecessary crosslinking among the component (A) or between the components (A) and (C) at the time of patterning, and contrast can be enhanced. In addition, by an anticorrosive effect to metal materials, it is possible to suppress oxidation of metal by water from outside, a photo-acid generator, a thermal acid generator, etc. and accompanying adhesion degradation and delamination.

Specific examples of antioxidants (H) that can be used here include hindered phenol-based antioxidants, phosphorus-based antioxidants, and sulfur-based antioxidants as preferable examples. However, the antioxidant is not limited thereto. Moreover, one of these antioxidants (H) can be used or two or more thereof can be used in combination.

Furthermore, out of the above-described specific examples of antioxidants (H), examples of the hindered phenol-based antioxidants include pentaerythritol tetrakis[3-(3,5-di-tert-butyl-4-hydroxyphenyl)propionate] (Irganox 1010 (trade name), manufactured by BASF Japan Ltd.), thiodiethylenebis[3-(3,5-di-tert-butyl-4-hydroxyphenyl)propionate] (Irganox 1035 (trade name), manufactured by BASF Japan Ltd.), octadecyl[3-(3,5-di-tert-butyl-4-hydroxyphenyl)propionate] (Irganox 1076 (trade name), manufactured by BASF Japan Ltd.), octyl-1-3,5-di-tert-butyl-4-hydroxy-hydrocinnamic acid (Irganox 1135 (trade name), manufactured by BASF Japan Ltd.), 4,6-bis(octylthiomethyl-o-cresol) (Irganox 1520L, manufactured by BASF Japan Ltd.), Sumilizer GA80 (trade name, manufactured by Sumitomo Chemical Co., Ltd.), Adekastab AO-20 (trade name, manufactured by ADEKA CORPORATION), Adekastab AO-30 (trade name, manufactured by ADEKA CORPORATION), Adekastab AO-40 (trade name, manufactured by ADEKA CORPORATION), Adekastab AO-50 (trade name, manufactured by ADEKA CORPORATION), Adekastab AO-60 (trade name, manufactured by ADEKA CORPORATION), Adekastab AO-80 (trade name, manufactured by ADEKA CORPORATION), Adekastab AO-330 (trade name, manufactured by ADEKA CORPORATION), hindered phenol-based antioxidants disclosed in WO 2017/188153 A1, and the like.

Furthermore, out of the above-described specific examples of antioxidants (H), examples of the phosphorus-based antioxidants include triphenyl phosphite, tris(methylphenyl) phosphite, triisooctyl phosphite, tridecyl phosphite, tris(2-ethylhexyl) phosphite, tris(nonylphenyl) phosphite, tris(octylphenyl) phosphite, tris[decylpoly(oxyethylene) phosphite, tris(cyclohexylphenyl) phosphite, tricyclohexyl phosphite, tri(decyl)thio phosphite, triisodecylthio phosphite, phenyl-bis(2-ethylhexyl) phosphite, phenyl-diisodecyl phosphite, tetradecylpoly(oxyethylene)-bis(ethylphenyl) phosphite, phenyl-dicyclohexyl phosphite, phenyl-diisooctyl phosphite, phenyl-di(tridecyl) phosphite, diphenyl-cyclohexyl phosphite, diphenyl-isooctyl phosphite, diphenyl-2-ethylhexyl phosphite, diphenyl-isodecyl phosphite, diphenyl-cyclohexylphenyl phosphite, diphenyl-(tridecyl)thio phosphite, and the like.

Furthermore, out of the above-described specific examples of antioxidants (H), examples of the sulfur-based antioxidants include Adekastab AO-412S (trade name, manufactured by ADEKA CORPORATION), AO-503S (trade name, manufactured by ADEKA CORPORATION), Sumilizer TP-D (trade name, manufactured by Sumitomo Chemical Co., Ltd.), and the like.

Sulfur-based antioxidants and phosphorus-based antioxidants can be expected to have an effect of decomposing peroxides.

The contained amount of the antioxidant (H) is preferably 0.1 to 10 parts by mass, more preferably 0.2 to 5 parts by mass relative to 100 parts by mass of the component (A) polymer. When the contained amount is 0.1 parts by mass or more, adhesiveness to metal materials is enhanced, while at the same time, delamination is suppressed. Meanwhile, when the contained amount is 10 parts by mass or less, the developing properties of the composition and the toughness of the cured film are not degraded.

The inventive negative photosensitive resin composition can further contain (I) a silane compound, in addition to the components (A), (B), (C), (D), and (E). When the component (I) silane compound is contained, not only is the adhesiveness to metal materials enhanced, it is also possible to suppress the delamination of the cured film in reliability tests such as a thermal shock test and a high temperature and high humidity test.

A silane compound (I) usable here is not particularly limited, but preferably has an alkoxysilyl group. Suitable, specific examples include the following: γ-glycidoxypropyltriethoxysilane, γ-glycidoxypropyltrimethoxysilane, 2-(3,4-epoxycyclohexyl)ethyltrimethoxysilane, bis(2-hydroxyethyl)-3-aminopropyl-triethoxysilane, γ-aminopropyltrimethoxysilane, γ-aminopropyltriethoxysilane, vinyltriethoxysilane, vinyltrimethoxysilane, γ-methacryloxypropyltrimethoxysilane, γ-acryloxypropyltrimethoxysilane, 3-mercaptopropyltrimethoxysilane, 3-isocyanatepropyltriethoxysilane, bis(2-hydroxyethyl)-3-aminopropyltriethoxysilane, triethoxysilylpropylethyl carbamate, 3-(triethoxysilyl)propyl succinic anhydride, phenyltriethoxysilane, phenyltrimethoxysilane, N-phenyl-3-aminopropyltrimethoxysilane, 3-triethoxysilyl-N-(1,3-dimethylbutylidene)propylamine, amide group-containing silane compounds disclosed in JP 6414060 B, thiourea group-containing silane compounds disclosed in WO 2016/140024 A1 and JP 5987984 B, thiol group-containing silane compounds disclosed in JP 2017-044964 A, and the like. However, the silane compound is not limited thereto. Furthermore, one of these silane compounds (I) can be used or a combination of two or more thereof can be used.

The contained amount of the silane compound (I) is preferably 0.1 to 20 parts by mass, more preferably 1 to 10 parts by mass, and further preferably 3 to 6 parts by mass relative to 100 parts by mass of the component (A) polymer. With 0.1 parts by mass or more, more sufficient adhesiveness with a substrate can be provided, and when 20 parts by mass or less, it is possible to further suppress the problem of increasing viscosity or the like when storing at room temperature. Meanwhile, when the contained amount is 10 parts by mass or less, degradation of the developing properties of the composition does not occur, and thus, development residue does not occur.

The inventive negative photosensitive resin composition can further contain (J) a surfactant. The surfactant (J) is preferably nonionic. Examples thereof include fluorine-based surfactants, specifically, perfluoroalkyl polyoxyethylene ethanols, fluorinated alkyl esters, perfluoroalkylamine oxides, fluorine-containing organosiloxane-based compounds, non-fluorine organosiloxane-based compounds, etc.

As these surfactants (J), commercially available products can be used. Examples thereof include Fluorad FC-4430 (trade name, manufactured by Sumitomo 3M Limited), PF-6320 (trade name, manufactured by OMNOVA Solutions Inc.), PF-636 (trade name, manufactured by OMNOVA Solutions Inc.), Surflon S-141 and S-145 (both trade names, manufactured by ASAHI GLASS CO., LTD.), UNIDYNE DS-401, DS-4031, and DS-451 (all trade names, manufactured by DAIKIN INDUSTRIES, LTD.), Megafac F-8151 (trade name, manufactured by DIC Corporation), X-70-093 and KP-341 (trade names, manufactured by Shin-Etsu Chemical Co., Ltd.), etc. Among these, preferred are Fluorad FC-4430 (trade name, manufactured by Sumitomo 3M Limited), PF-6320 (trade name, manufactured by OMNOVA Solutions Inc.), PF-636 (trade name, manufactured by OMNOVA Solutions Inc.), and KP-341 (trade name, manufactured by Shin-Etsu Chemical Co., Ltd.).

The amount of the surfactant (J) to be contained is preferably 0.01 to 0.05 parts by mass based on 100 parts by mass of the component (A) polymer. When the amount is in such a range, there is an advantage that coatability on a substrate can be improved without degradation of patterning properties or properties of the cured film.

The inventive negative photosensitive resin composition can further contain (K) a sensitizer. Examples of the sensitizer (K) include Michler's ketone, 4,4'-bis(diethylamino)benzophenone, 2,5-bis(4'-diethylaminobenzal)cyclopentane, 2,6-bis(4'-diethylaminobenzal)cyclohexanone, 2,6-bis(4'-diethylaminobenzal)-4-methylcyclohexanone, 4,4'-bis(dimethylamino)chalcone, 4,4'-bis(diethylamino)chalcone, p-dimethylaminocinnamylideneindanone, p-dimethylaminobenzylideneindanone, 2-(p-dimethylaminophenylbiphenylene)-benzothiazole, 2-(p-dimethylaminophenylvinylene)benzothiazole, 2-(p-dimethylaminophenylvinylene)isonaphthothiazole, 1,3-bis(4'-dimethylaminobenzal)acetone, 1,3-bis(4'-diethylaminobenzal)acetone, 3,3'-carbonyl-bis(7-diethylaminocoumarin), 3-acetyl-7-dimethylaminocoumarin, 3-ethoxycarbonyl-7-dimethylaminocoumarin, 3-benzyloxycarbonyl-7-dimethylaminocoumarin, 3-methoxycarbonyl-7-diethylaminocoumarin, 3-ethoxycarbonyl-7-diethylaminocoumarin, N-phenyl-N'-ethylethanolamine, N-phenyldiethanolamine, N-p-tolyldiethanolamine, N-phenylethanolamine, 4-morpholinobenzophenone, isoamyl dimethylaminobenzoate, isoamyl diethylaminobenzoate, 2-mercaptobenzimidazole, 1-phenyl-5-mercaptotetrazole, 2-mercaptobenzothiazole, 2-(p-dimethylaminostyryl)benzoxazole, 2-(p-dimethylaminostyryl)benzthiazole, 2-(p-dimethylaminostyryl)naphtho(1,2-d)thiazole, 2-(p-dimethylaminobenzoyl)styrene, etc. One of these may be used, or for example, a combination of 2 to 5 kinds thereof may be used.

The amount of the sensitizer (K) to be contained is preferably 0.05 to 20 parts by mass, more preferably 0.1 to 10 parts by mass based on 100 parts by mass of the component (A) polymer.

### (Patterning Process)

Next, patterning processes using the inventive negative photosensitive resin composition will be described.

A pattern of the inventive negative photosensitive resin composition may be formed by employing a known lithography technology. For example, a silicon wafer, an SiO₂ substrate, an SiN substrate, or a substrate on which a pattern of copper wiring or the like has been formed is coated with the negative photosensitive resin composition by a spin coating technique (spin coating method) and pre-baked under conditions of about 80 to 130°C for about 50 to 600 seconds to form a photosensitive material film with a thickness of 1 to 50 µm, preferably 1 to 30 µm, further preferably 5 to 20 µm.

In the spin coating method, the negative photosensitive resin composition can be applied onto the silicon substrate by dispensing the negative photosensitive resin composition onto the substrate in an amount of approximately 5 mL, and then rotating the substrate. Upon this, the film thickness of the photosensitive material film on the substrate can be readily controlled by adjusting the rotation speed. Then, the remaining solvent can be removed by prebaking.

Then, a mask for forming the target pattern is put on the photosensitive material film, and exposure is performed with a high energy beam, such as i-line and g-line, having a wavelength of 190 to 500 nm or an electron beam with an exposure value of approximately 1 to 5,000 mJ/cm², preferably approximately 100 to 2,000 mJ/cm².

After that, development is performed. For the above-described inventive negative photosensitive resin composition, development with an organic solvent is possible in the case of any constitution.

As a suitable organic solvent usable for the development with the organic solvent, it is possible to use a solvent given above used for the preparation of the inventive negative photosensitive resin composition. Preferable examples include ketones, such as cyclohexanone and cyclopentanone, and furthermore, glycols, such as propylene glycol monomethyl ether. The development can be carried out by normal methods such as spray method and paddle method, or by dipping the film in a developing solution, for example. Thereafter, by carrying out washing, rinsing, drying, and the like, as necessary, a resist film having a desired pattern can be obtained.

### (Method for Forming Cured Film)

By heating and post-curing the patterned film obtained by the above-described patterning process at a temperature of 100 to 300°C, preferably 150 to 300°C, and further preferably 180 to 250°C, using an oven, a hot plate, etc., a cured film can be formed. When the post-curing temperature is 100 to 300°C, the crosslinking density of the film of the photosensitive resin composition can be increased and the remaining volatile components can be removed. The post-curing temperature is preferable from the viewpoints of adhesiveness to the substrate, heat resistance and strength, as well as electrical properties. The post-curing time can be 10 minutes to 10 hours.

The formed pattern described above is used for a protective film that covers a wiring, circuit, substrate and the like. Such a formed pattern and protective film have excellent insulating property, and also exhibit excellent adhesive force to wirings to be covered, to a metal layer of a circuit such as Cu, on a metal electrode existing on the substrate, or on an insulating substrate such as SiN existing in wirings or circuits to be coated. Furthermore, the pattern and protective film can also significantly improve the resolution performance for realizing further finer patterning, while having the appropriate mechanical strength as a protective film.

### (Cured Film)

The cured film thus obtained is excellent in adhesiveness to a substrate, heat resistance, electrical properties, mechanical strength and chemical resistance to an alkaline stripping solution and the like. A semiconductor device using the cured film as a protective film is also excellent in reliability. In particular, the cured film can prevent cracking upon a temperature cycle test. Therefore, the cured film is suitably used as a protective film (interlayer insulating film or surface protective film) for electrical and electronic components, semiconductor devices, etc.

Thus, the present invention provides an interlayer insulating film or a surface protective film including a cured film obtained by curing the above-described negative photosensitive resin composition.

The protective films are effective for applications as an insulating film for semiconductor devices including a rewiring application, an insulating film for multilayer printed circuit board, a solder mask, a coverlay film, and so forth, because the protective films have the heat resistance, chemical resistance, and insulating property.

Furthermore, the present invention provides an electronic component having the interlayer insulating film or surface protective film described above.

Such an electronic component has a protective film (interlayer insulating film or surface protective film) with heat resistance, chemical resistance, and insulating property, and is thus excellent in reliability.

### EXAMPLES

Hereinafter, the present invention will be described specifically with reference to Synthesis Examples, Comparative Synthesis Examples, Examples, and Comparative Examples, but the present invention is not limited by the following Examples.

### I. Synthesis of Polymers

Chemical structural formulae and names of the compounds used in the following Synthesis Examples are shown below. 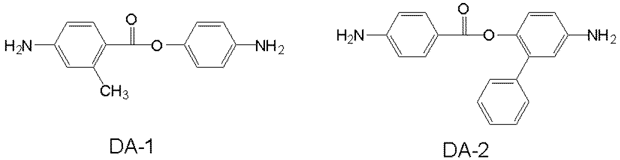 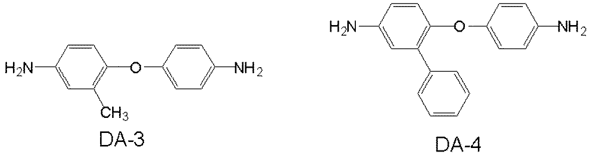 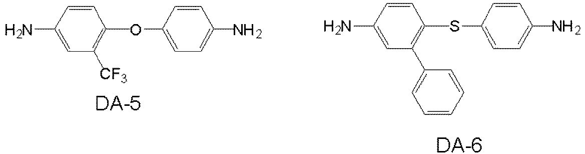 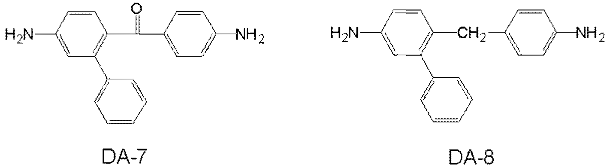 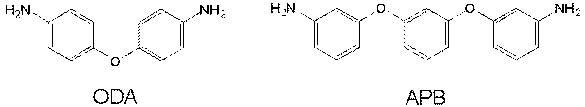 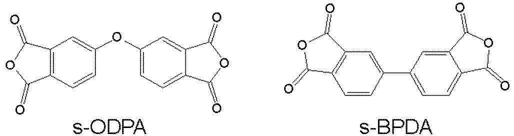 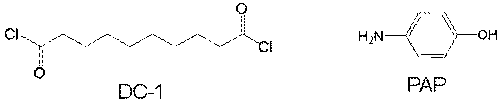 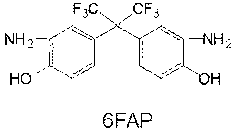
DA-1 4-aminophenyl-4-amino-2-methylbenzoate
DA-2 (2-phenyl-4-aminophenyl)-4-aminobenzoate
DA-3 4-(4-aminophenoxy)-3-methylbenzenamine
DA-4 2-phenyl-4,4'-diaminodiphenyl ether
DA-5 4-(4-aminophenoxy)-3-(trifluoromethyl)benzenamine
DA-6 4-((4-aminophenyl)thio)-3-phenylbenzenamine
DA-7 (4-amino-2-(phenyl)phenyl) (4-aminophenyl)methanone
DA-8 4-((4-aminophenyl)methyl)-3-phenylbenzenamine
ODA 4,4'-diaminodiphenyl ether
APB 1,3-bis(3-aminophenoxy)benzene
s-ODPA 3,3',4,4'-oxydiphthalic dianhydride
s-BPDA 3,3',4,4'-biphenyltetracarboxylic dianhydride
DC-1 sebacic acid dichloride
PAP 4-aminophenol
6FAP 2,2-bis(3-amino-4-hydroxyphenyl)hexafluoropropane

### [Synthesis Example 1] Synthesis of Tetracarboxylic Acid Diester Compound (X-1)

Into a 3-L flask provided with a stirrer and a thermometer, 100 g (322 mmol) of 3,3',4,4'-oxydiphthalic dianhydride (s-ODPA), 65.2 g (644 mmol) of triethylamine, 39.3 g (322 mmol) of N,N-dimethyl-4-aminopyridine, and 400 g of γ-butyrolactone were added, under stirring at room temperature, 83.8 g (644 mmol) of hydroxyethylmethacrylate (HEMA) was dropped thereto, followed by stirring for 24 hours under room temperature. After that, 370 g of a 10% aqueous solution of hydrochloric acid was dropped in under ice cooling to terminate the reaction. To the reaction liquid, 800 g of 4-methyl-2-pentanone was added to sample an organic layer, followed by washing 6 times with 600 g of water. A solvent of the obtained organic layer was distilled off and 180 g of a tetracarboxylic acid diester compound (X-1) of the following structure was obtained.

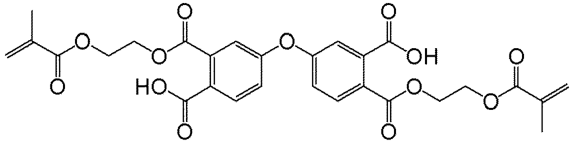

### [Synthesis Example 2] Synthesis of Tetracarboxylic Acid Diester Compound (X-2)

According to Synthesis Example 1, 172 g of a tetracarboxylic acid diester compound (X-2) of the following structure was obtained in the same manner except that the 3,3',4,4'-oxydiphthalic dianhydride (s-ODPA) was changed to 94.8 g (322 mmol) of 3,3',4,4'-biphthalic dianhydride (s-BPDA).

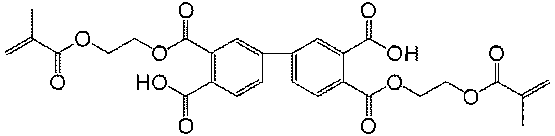

### [Synthesis Example 3] Synthesis of Polyimide Precursor (A-1)

Into a 1-L flask provided with a stirrer and a thermometer, 44.0 g (77.1 mmol) of X-1 and 176 g of N-methyl-2-pyrrolidone were added, followed by dissolving by stirring at room temperature. Next, under ice cooling, 18.8 g (158.1 mmol) of thionyl chloride was dropped thereto so as to keep the reaction solution temperature to 10°C or lower. After completion of the dropping, the solution was stirred under ice cooling for 2 hours. Subsequently, a solution obtained by dissolving 17.4 g (71.7 mmol) of DA-1 and 25.0 g (316.2 mmol) of pyridine with 70 g of N-methyl-2-pyrrolidone was dropped thereto under ice cooling so as to keep the reaction solution temperature to 10°C or lower. After completion of the dropping, the temperature was restored to room temperature, and the reaction liquid was dropped into 3 L of water under stirring. A precipitate was collected by filtration to be washed appropriately with water, followed by drying under reduced pressure at 40°C for 48 hours. Thus, a polyimide precursor (A-1) was obtained. The molecular weight of the polymer was measured by GPC. The weight-average molecular weight was 25,000 in terms of polystyrene.

### [Synthesis Example 17] Synthesis of Polyimide Precursor (A-15)

Into a 1-L flask provided with a stirrer and a thermometer, 44.0 g (77.1 mmol) of X-1 and 176 g of N-methyl-2-pyrrolidone were added, followed by dissolving by stirring at room temperature. Next, under ice cooling, 18.8 g (158.1 mmol) of thionyl chloride was dropped thereto so as to keep the reaction solution temperature to 10°C or lower. After completion of the dropping, the solution was stirred under ice cooling for 2 hours. Subsequently, 4.6 g (19.3 mmol) of DC-1 was added thereto, and then a solution obtained by dissolving 2.9 g (9.6 mmol) of DA-2, 16.4 g (81.9 mmol) of ODA, 1.0 g (9.6 mmol) of PAP, and 15.3 g (192.8 mmol) of pyridine with 135 g of N-methyl-2-pyrrolidone was dropped thereto under ice cooling so as to keep the reaction solution temperature to 10°C or lower. After completion of the dropping, the temperature was restored to room temperature, and the reaction liquid was dropped into 3 L of water under stirring. A precipitate was collected by filtration to be washed appropriately with water, followed by drying under reduced pressure at 40°C for 48 hours. Thus, a polyimide precursor (A-15) was obtained. The molecular weight of the polymer was measured by GPC. The weight-average molecular weight was 32,000 in terms of polystyrene.

### [Synthesis Example 18] Synthesis of Polyimide Resin (A-16)

Into a 1-L flask provided with a stirrer and a thermometer, 31.0 g (100.0 mmol) of s-ODPA and 279 g of N-methyl-2-pyrrolidone were added, followed by dissolving by stirring at room temperature. Next, under room temperature, a solution in which 15.2 g (50.0 mmol) of DA-2, 9.0 g (45.0 mmol) of ODA, and 1.1 g (10.0 mmol) of PAP were dissolved in 228 g of N-methyl-2-pyrrolidone was dropped thereto, followed by stirring for 1 hour under room temperature after dropping. Thereafter, 30 g of xylene was added to the reaction liquid, followed by heating and refluxing for 3 hours while removing water generated at 180°C outside the system. After cooling to room temperature, the reaction liquid was dropped into 2 L of ultrapure water under stirring, a precipitate was collected by filtration to be washed appropriately with water, followed by drying under reduced pressure at 40°C for 48 hours. Thus, a polyimide resin (A-16) was obtained. The molecular weight of the polymer was measured by GPC. The weight-average molecular weight was 34,000 in terms of polystyrene.

### [Synthesis Example 19] Synthesis of Polyamide Resin (A-17)

Into a 1-L flask provided with a stirrer and a thermometer, 15.2 g (50.0 mmol) of DA-2, 9.0 g (45.0 mmol) of ODA, 1.1 g (10.0 mmol) of PAP, and 228 g of N-methyl-2-pyrrolidone were added, followed by dissolving by stirring at room temperature. Next, 15.8 g (200.0 mmol) of pyridine was added thereto, and 23.9 g (100.0 mmol) of DC-1 was dropped thereto so as to keep the temperature to 20°C or lower. After completion of the dropping, the reaction liquid was dropped into 2 L of ultrapure water under stirring. A precipitate was collected by filtration to be washed appropriately with water, followed by drying under reduced pressure at 40°C for 48 hours. Thus, a polyamide resin (A-17) was obtained. The molecular weight of the polymer was measured by GPC. The weight-average molecular weight was 38,000 in terms of polystyrene.

### [Synthesis Example 4] to [Synthesis Example 16], [Synthesis Example 20], and [Comparative Synthesis Examples 1 and 2] Synthesis of Polyimide Precursors (A-2) to (A-14) and (A-18) to (A-20)

Using the compounds in the weight shown in Table 1 below as tetracarboxylic acid diester compounds, diamine compounds, monoamine compounds, tetracarboxylic dianhydrides, and a dicarboxylic acid dichloride, (A-2) to (A-14) and (A-18) to (A-20) were obtained by a method similar to that in Synthesis Example 3. The molecular weight of each polymer was measured by GPC using DMF as an eluent under the condition of 40°C. The weight-average molecular weight in terms of polystyrene is shown in Table 1 below.

**[Table 1]**

| | | Tetracarboxylic acid diester compound | | Diamine compound | | Monoamine compound | Tetra-carboxylic dianhydride | Dicarboxylic acid dichloride | Molecular weight |
|---|---|---|---|---|---|---|---|---|---|
| Synthesis Example 3 | A-1 | X-1 44.0 g (77.1 mmol) | | DA-1 17.4 g (71.7 mmol) | | | | | 25,000 |
| Synthesis Example 4 | A-2 | X-1 44.0 g (77.1 mmol) | | DA-2 21.8 g (71.7 mmol) | | | | | 23,000 |
| Synthesis Example 5 | A-3 | X-1 44.0 g (77.1 mmol) | | DA-3 15.4 g (71.7 mmol) | | | | | 23,000 |
| Synthesis Example 6 | A-4 | X-1 44.0 g (77.1 mmol) | | DA-4 19.8 g (71.7 mmol) | | | | | 22,000 |
| Synthesis Example 7 | A-5 | X-1 44.0 g (77.1 mmol) | | DA-5 19.2 g (71.7 mmol) | | | | | 24,000 |
| Synthesis Example 8 | A-6 | X-1 44.0 g (77.1 mmol) | | DA-6 21.0 g (71.7 mmol) | | | | | 23,000 |
| Synthesis Example 9 | A-7 | X-1 44.0 g (77.1 mmol) | | DA-7 20.7 g (71.7 mmol) | | | | | 21,000 |
| Synthesis Example 10 | A-8 | X-1 44.0 g (77.1 mmol) | | DA-8 19.7 g (71.7 mmol) | | | | | 22,000 |
| Synthesis Example 11 | A-9 | X-2 42.8 g (77.1 mmol) | | DA-1 17.4 g (71.7 mmol) | | | | | 23,000 |
| Synthesis Example 12 | A-10 | X-2 42.8 g (77.1 mmol) | | DA-2 21.8 g (71.7 mmol) | | | | | 22,000 |
| Synthesis Example 13 | A-11 | X-2 42.8 g (77.1 mmol) | | DA-4 19.8 g (71.7 mmol) | | | | | 22,000 |
| Synthesis Example 14 | A-12 | X-1 22.0 g (38.6 mmol) | X-2 21.4 g (38.6 mmol) | DA-1 8.4 g (34.7 mmol) | ODA 7.7 g (38.6 mmol) | PAP 0.8 g (7.7 mmol) | | | 25,000 |
| Synthesis Example 15 | A-13 | X-1 22.0 g (38.6 mmol) | X-2 21.4 g (38.6 mmol) | DA-2 106 g (34.7 mmol) | ODA 7.7 g (38.6 mmol) | PAP 0.8 g (7.7 mmol) | | | 24,000 |
| Synthesis Example 16 | A-14 | X-1 22.0 g (38.6 mmol) | X-2 21.4 g (38.6 mmol) | DA-4 9.6 g (34.7 mmol) | APB 11.3 g (38.6 mmol) | PAP 0.8 g (7.7 mmol) | | | 25,000 |
| Synthesis Example 17 | A-15 | X-1 44.0 g (77.1 mmol) | | DA-2 2.9 g (9.6 mmol) | ODA 16.4 g (81.9 mmol) | PAP 1.0 g (9.6 mmol) | | DC-1 4.6 g (19.3 mmol) | 32,000 |
| Synthesis Example 18 | A-16 | | | DA-2 15.2 g (50.0 mmol) | ODA 9.0 g (45 mmol) | PAP 1.1 g (10.0 mmol) | s-ODPA 31.0 g (100.0 mmol) | | 34,000 |
| Synthesis Example 19 | A-17 | | | DA-2 15.2 g (50.0 mmol) | ODA 9.0 g (45 mmol) | PAP 1.1 g (10.0 mmol) | | DC-1 23.9 g (100.0 mmol) | 38,000 |
| Synthesis Example 20 | A-18 | | | 6FAP 34.8 g (95.0 mmol) | | PAP 1.1 g (10.0 mmol) | | DC-1 23.9 g (100.0 mmol) | 40,000 |
| Comparative Synthesis Example 1 | A-19 | X-1 44.0 g (77.1 mmol) | | ODA 14.4 g (71.7 mmol) | | | | | 24,000 |
| Comparative Synthesis Example 2 | A-20 | X-1 22.0 g (38.6 mmol) | X-2 21.4 g (38.6 mmol) | ODA 14.7 g (73.3 mmol) | | PAP 0.8 g (7.7 mmol) | | | 23,000 |

### II. Preparation of Photosensitive Resin Composition

Using the polymers synthesized in the above-described Synthesis Example 3 to Synthesis Example 20 and Comparative Synthesis Examples 1 and 2 as base resins, 35 mass% resin compositions in terms of resin were prepared with the compositions and blending amounts described in Table 2. Thereafter, after stirring, mixing, and dissolving, micro-filtering was applied with a Teflon (registered trademark) 1.0 µm filter to obtain a photosensitive resin composition. In the Table, the solvent GBL represents γ-butyrolactone.

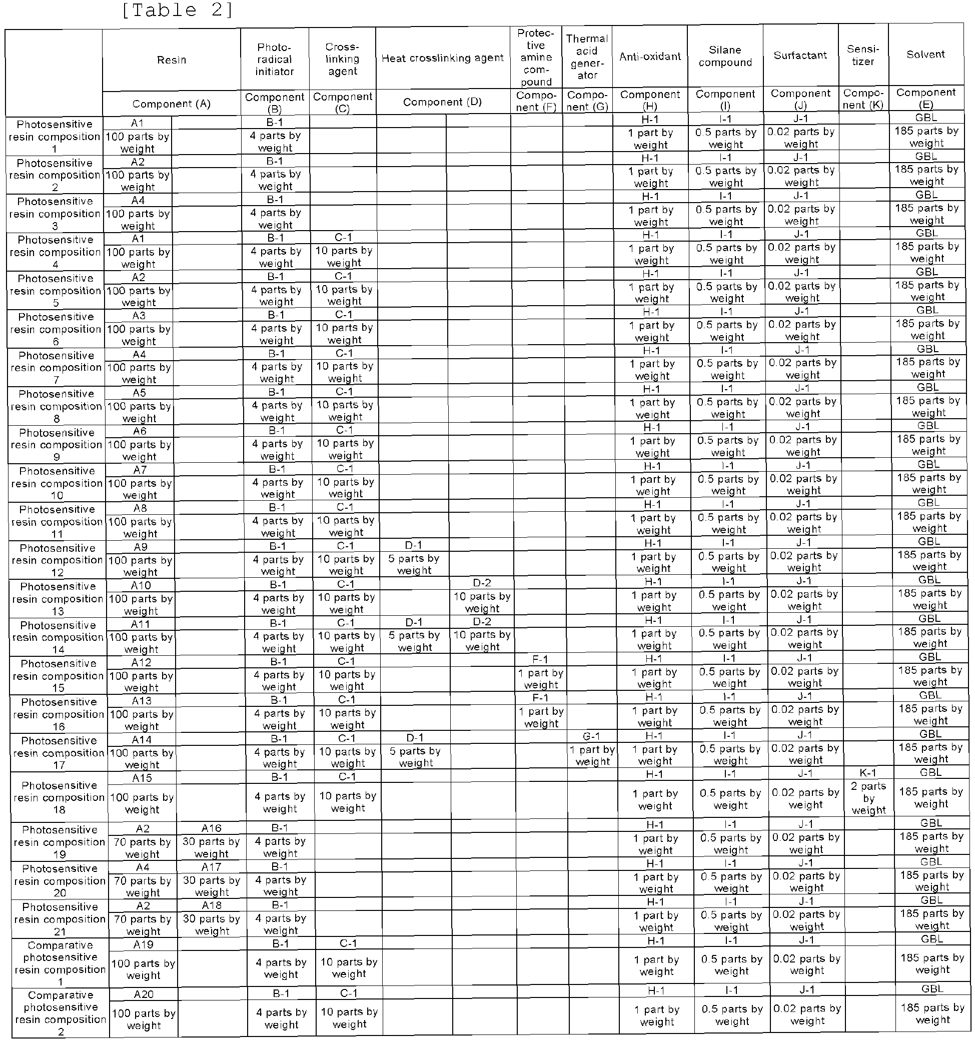

The photosensitive resin compositions 1 to 21 shown in Table 2 relate to the inventive negative photosensitive resin composition described above. The comparative photosensitive resin compositions 1 and 2 are compositions in which the polymers synthesized in Comparative Synthesis Examples 1 and 2 are used instead of the inventive polymers as the base resin in the inventive negative photosensitive resin compositions described above.

Note that, in Table 2, details of the photo-radical initiator (B-1), crosslinking agent (C-1), heat crosslinking agents (D-1) and (D-2), protective amine compound (F-1), thermal acid generator (G-1), antioxidant (H-1), silane compound (I-1), surfactant (J-1), and sensitizer (K-1) are as follows. "Parts by weight" has the same meaning as "parts by mass".
Photo-radical initiator (B-1): N-1919 manufactured by ADEKA CORPORATION
Crosslinking agent (C-1): tetraethylene glycol dimethacrylate
Heat crosslinking agent (D-1) 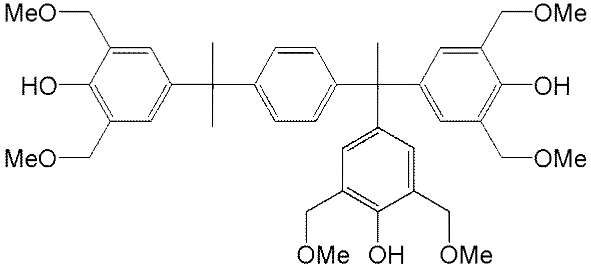
Heat crosslinking agent (D-2)
Epoxy resin: EP4000L manufactured by ADEKA CORPORATION
Protective amine compound (F-1) 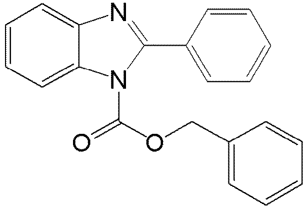
Thermal acid generator (G-1) 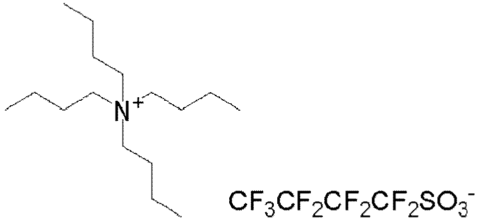
Antioxidant (H-1)
Hindered phenol-based antioxidant: Sumilizer GA-80 manufactured by Sumitomo Chemical Co., Ltd.
Silane compound (I-1)
Amino silane coupling agent: KBM-573 manufactured by Shin-Etsu Chemical Co., Ltd.
Surfactant (J-1)
Silicone-based surfactant: KP-341 manufactured by Shin-Etsu Chemical Co., Ltd.
Sensitizer (K-1)
N-phenyldiethanolamine
III. Pattern formation

By rotating a substrate after each of the photosensitive resin compositions 1 to 21 and comparative photosensitive resin compositions 1 and 2 was dispensed by 5 mL on a silicon substrate, that is, by a spin-coating method, the photosensitive resin composition was applied such that a film thickness was 5 µm after patterning and heating for the post-curing. That is, by studying in advance that after the post-curing step, the film thickness decreases, the rotational rate during coating was adjusted such that a finishing film thickness after the post-curing was 5 µm.

Next, the compositions applied on the substrates were pre-baked on a hot plate at 100°C for 2 minutes. Then, an i-line stepper NSR-2205i11 manufactured by Nikon Corporation was used for i-line exposure and patterning. In the patterning, a mask for positive pattern or negative pattern was used appropriately in accordance with the photosensitive resin compositions used. The mask has a pattern capable of forming 20 µm holes arranged by a fineness ratio of 1:1, and can form a hole pattern of 50 µm to 20 µm holes with 10 µm pitch, 20 µm to 10 µm holes with 5 µm pitch, and 10 µm to 1 µm holes with 1 µm pitch.

In the development step, cyclopentanone was used as the developing solution. For development with an organic solvent, 1-minute spray development with each organic solvent was performed once, and rinsing was performed with isopropyl alcohol.

Then, the obtained pattern on the substrate was post-cured using an oven at 250°C for 2 hours while the oven was purged with nitrogen.

Next, each substrate was cut out so that the shape of the obtained hole pattern could be observed, and the shape of the hole pattern was observed by using a scanning electron microscope (SEM). The aperture of the smallest opening hole at a film thickness of 5 µm after the post-curing was determined, and the pattern shape was evaluated. Together with these results, the sensitivities at which the minimum pattern was successfully formed are shown in Table **3.**

Note that the shape of the hole pattern was evaluated by the criteria as described below, and the evaluation results were shown in Table 3.
Good: holes were observed in a rectangular shape or forward taper shape (the shape in which the dimension of the upper part of a hole is larger than the dimension of the bottom part)
Poor: holes were observed in a reverse taper shape (the shape in which the dimension of the upper part of a hole is smaller than the dimension of the bottom part) or overhang shape (the shape in which the upper part of a hole protrudes), remarkable film thinning was observed, or residue was observed at the bottom part of a hole

### IV. Rupture Elongation and Rupture Strength

Each of the photosensitive resin compositions 1 to 21 and the comparative photosensitive resin compositions 1 and 2 was respectively applied onto an aluminum substrate by spin-coating so that a finishing film thickness after curing was 10 µm. Next, pre-baking was performed on a hot plate at 100°C for 4 minutes, and then the entire surface was exposed by broadband exposure with an exposure dose of 1000 mJ/cm² to obtain a resin film.

Thereafter, curing was performed with an oven at 250°C for 2 hours while purging with nitrogen to obtain a resin cured film. Next, a wafer with a cured film was cut in strips of a width of 10 mm and a length of 60 mm, followed by peeling the cured film from the substrate by dipping in hydrochloric acid of 20 mass%. The obtained cured film was subjected to a measurement of the rupture elongation and rupture strength using an Autograph AGX-1KN manufactured by Shimadzu Corporation. The measurement was performed 10 times per sample, and an average value thereof is shown in Table 3.

The results obtained by carrying out the patterning using the negative photosensitive resin compositions (photosensitive resin compositions 1 to 21 and comparative photosensitive resin compositions 1 and 2) and the rupture elongation and rupture strength of the cured film are shown in Table 3.

**[Table 3]**

| | Composition | Hole shape | Minimum hole diameter (um) | Sensitivity (mJ/cm²) | Rupture elongation (%) | Rupture strength (MPa) |
|---|---|---|---|---|---|---|
| Example 1 | Photosensitive resin composition 1 | Good | 5 | 400 | 45 | 110 |
| Example 2 | Photosensitive resin composition 2 | Good | 5 | 400 | 50 | 115 |
| Example 3 | Photosensitive resin composition 3 | Good | 5 | 380 | 55 | 118 |
| Example 4 | Photosensitive resin composition 4 | Good | 5 | 380 | 58 | 115 |
| Example 5 | Photosensitive resin composition 5 | Good | 5 | 380 | 60 | 120 |
| Example 6 | Photosensitive resin composition 6 | Good | 5 | 380 | 55 | 115 |
| Example 7 | Photosensitive resin composition 7 | Good | 5 | 380 | 60 | 115 |
| Example 8 | Photosensitive resin composition 8 | Good | 5 | 380 | 55 | 112 |
| Example 9 | Photosensitive resin composition 9 | Good | 5 | 380 | 56 | 118 |
| Example 10 | Photosensitive resin composition 10 | Good | 5 | 380 | 56 | 115 |
| Example 11 | Photosensitive resin composition 11 | Good | 5 | 380 | 54 | 114 |
| Example 12 | Photosensitive resin composition 12 | Good | 5 | 400 | 58 | 128 |
| Example 13 | Photosensitive resin composition 13 | Good | 5 | 400 | 65 | 120 |
| Example 14 | Photosensitive resin composition 14 | Good | 5 | 400 | 62 | 122 |
| Example 15 | Photosensitive resin composition 15 | Good | 5 | 400 | 65 | 130 |
| Example 16 | Photosensitive resin composition 16 | Good | 5 | 400 | 68 | 135 |
| Example 17 | Photosensitive resin composition 17 | Good | 5 | 400 | 65 | 130 |
| Example 18 | Photosensitive resin composition 18 | Good | 4 | 420 | 58 | 120 |
| Example 19 | Photosensitive resin composition 19 | Good | 4 | 420 | 60 | 125 |
| Example 20 | Photosensitive resin composition 20 | Good | 4 | 400 | 70 | 120 |
| Example 21 | Photosensitive resin composition 21 | Good | 4 | 400 | 72 | 123 |
| Comparative Example 1 | Comparative Photosensitive resin composition 1 | Good | 5 | 400 | 38 | 105 |
| Comparative Example 2 | Comparative Photosensitive resin composition 2 | Good | 5 | 400 | 40 | 110 |

As shown in Table 3, the inventive negative photosensitive resin compositions, which contained, as the component (A), a polymer in which at least one of the R₁ to R₄ shown in the general formula (1) is a monovalent organic group having 1 to 15 carbon atoms and optionally containing a heteroatom, exhibit good pattern shape in the development with the cyclopentanone, and the minimum hole dimensions thereof exhibit values of 5 µm or less for the finishing film thickness of 5 µm. This verified that the aspect ratio of 1 or more can be achieved.

In addition, the inventive negative photosensitive resin compositions successfully gave a cured film having excellent mechanical properties even when cured at a low temperature of 250°C or lower.

Meanwhile, the cured films obtained using the comparative photosensitive resin composition 1 and the comparative photosensitive resin composition 2, which contained, as the component (A), a polymer in which all of the R₁ to R₄ shown in the general formula (1) are hydrogen atoms, had a pattern shape and minimum hole dimensions equivalent to those of the inventive compositions, but regarding mechanical properties, the comparative compositions had both poor rupture elongation and poor rupture strength compared to those of the cured film obtained from the inventive compositions.

The present description includes the following embodiments.
[1]: A polymer having a polyimide precursor, wherein the polymer comprises a structural unit represented by the following general formula (1), 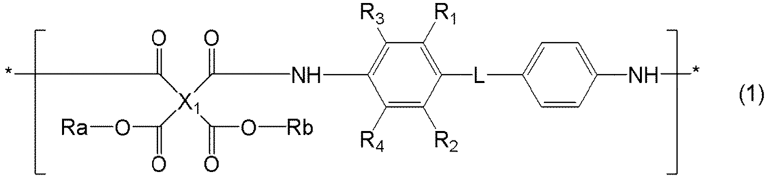 wherein X₁ represents a tetravalent organic group; R₁ to R₄ are each different from or identical to each other and represent a monovalent organic group having 1 to 15 carbon atoms and optionally containing a heteroatom or represent a hydrogen atom, provided that at least one of R₁ to R₄ represents a monovalent organic group having 1 to 15 carbon atoms and optionally containing a heteroatom; L represents a divalent linking group; Ra and Rb each independently represent a hydrogen atom, a linear, branched, or cyclic alkyl group having 1 to 6 carbon atoms, or an organic group represented by the following general formula (2), provided that at least one of Ra and Rb represents an organic group represented by the following general formula (2), 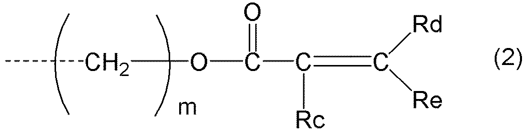 wherein a dotted line represents an attachment point; Rc represents a hydrogen atom or an organic group having 1 to 3 carbon atoms; Rd and Re each independently represent a hydrogen atom or an organic group having 1 to 3 carbon atoms; and "m" represents an integer of 2 to 10.
[2]: The polymer according to [1], wherein in the general formula (1), either one of the R₁ and the R₂ represents a monovalent organic group having 1 to 15 carbon atoms and optionally containing a heteroatom, the other of the R₁ and the R₂ represents a hydrogen atom, and the R₃ and the R₄ each represent a hydrogen atom.
[3]: The polymer according to [1] or [2], wherein in the general formula (1), either one of the R₁ and the R₂ represents an aromatic group having 6 to 12 carbon atoms, and the other of the R₁ and the R₂ represents a hydrogen atom.
[4]: The polymer according to any one of [1] to [3], wherein the L in the general formula (1) is at least one atom or organic group selected from any of an oxygen atom, a sulfur atom, an ester group, a carbonyl group, a linear alkylene group having 1 to 15 carbon atoms, and a branched alkylene group having 3 to 15 carbon atoms.
[5]: The polymer according to any one of [1] to [4], wherein the L in the general formula (1) is a least one atom or organic group selected from either of an oxygen atom and an ester group.
[6]: A negative photosensitive resin composition comprising:
   (A) the polymer according to any one of [1] to [5];
   (B) a photo-radical initiator; and
   (E) a solvent.
[7]: The negative photosensitive resin composition according to [6], further comprising, as a component (C), a crosslinking agent having two or more photopolymerizable unsaturated bond groups in one molecule.
[8]: The negative photosensitive resin composition according to [6] or [7], comprising, as (D) a heat crosslinking agent, one or more crosslinking agents selected from the group consisting of an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (D-1), and a compound containing two or more nitrogen atoms each having a glycidyl group represented by the following formula (D-2), 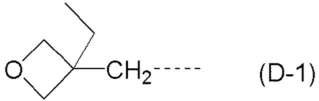 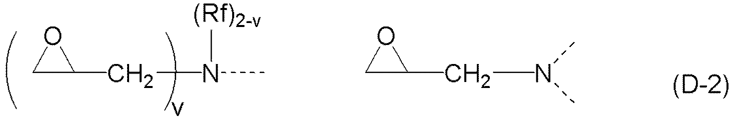 wherein a dotted line represents an attachment point; Rf represents a linear, branched, or cyclic alkyl group having 1 to 6 carbon atoms; and "v" represents 1 or 2.
[9]: The negative photosensitive resin composition according to any one of [6] to [8], further comprising one or more of (F) a protective amine compound, (G) a thermal acid generator, (H) an antioxidant, and (I) a silane compound.
[10]: A patterning process comprising the steps of:
   (1) applying the negative photosensitive resin composition according to any one of [6] to [9] onto a substrate to form a photosensitive material film;
   (2) heating the photosensitive material film;
   (3) exposing the photosensitive material film with a high-energy beam having a wavelength of 190 to 500 nm or an electron beam through a photomask; and
   (4) performing development using a developing solution of an organic solvent.
[11]: A method for forming a cured film, comprising heating and post-curing a patterned film obtained by the patterning process according to [10] at a temperature of 100 to 300°C.
[12]: An interlayer insulating film comprising a cured film of the negative photosensitive resin composition according to any one of [6] to [9].
[13]: A surface protective film comprising a cured film of the negative photosensitive resin composition according to any one of [6] to [9].
[14]: An electronic component comprising the interlayer insulating film according to [12].
[15]: An electronic component comprising the surface protective film according to [13].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A polymer having a polyimide precursor, wherein the polymer comprises a structural unit represented by the following general formula (1), 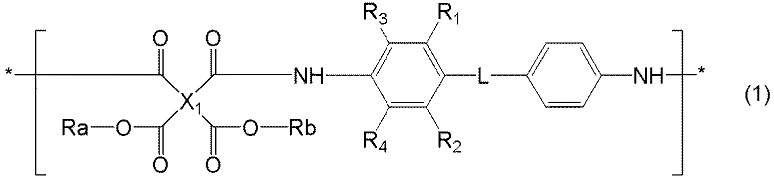 wherein X₁ represents a tetravalent organic group; R₁ to R₄ are each different from or identical to each other and represent a monovalent organic group having 1 to 15 carbon atoms and optionally containing a heteroatom or represent a hydrogen atom, provided that at least one of R₁ to R₄ represents a monovalent organic group having 1 to 15 carbon atoms and optionally containing a heteroatom; L represents a divalent linking group; Ra and Rb each independently represent a hydrogen atom, a linear, branched, or cyclic alkyl group having 1 to 6 carbon atoms, or an organic group represented by the following general formula (2), provided that at least one of Ra and Rb represents an organic group represented by the following general formula (2), 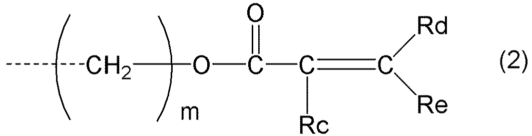 wherein a dotted line represents an attachment point; Rc represents a hydrogen atom or an organic group having 1 to 3 carbon atoms; Rd and Re each independently represent a hydrogen atom or an organic group having 1 to 3 carbon atoms; and "m" represents an integer of 2 to 10.

2. The polymer according to claim 1, wherein in the general formula (1), either one of the R₁ and the R₂ represents a monovalent organic group having 1 to 15 carbon atoms and optionally containing a heteroatom, the other of the R₁ and the R₂ represents a hydrogen atom, and the R₃ and the R₄ each represent a hydrogen atom.

3. The polymer according to claim 1 or 2, wherein in the general formula (1), either one of the R₁ and the R₂ represents an aromatic group having 6 to 12 carbon atoms, and the other of the R₁ and the R₂ represents a hydrogen atom.

4. The polymer according to any one of claims 1 to 3, wherein the L in the general formula (1) is at least one atom or organic group selected from any of an oxygen atom, a sulfur atom, an ester group, a carbonyl group, a linear alkylene group having 1 to 15 carbon atoms, and a branched alkylene group having 3 to 15 carbon atoms.

5. The polymer according to any one of claims 1 to 4, wherein the L in the general formula (1) is a least one atom or organic group selected from either of an oxygen atom and an ester group.

6. A negative photosensitive resin composition comprising:
(A) the polymer according to any one of claims 1 to 5;
(B) a photo-radical initiator; and
(E) a solvent.

7. The negative photosensitive resin composition according to claim 6, further comprising, as a component (C), a crosslinking agent having two or more photopolymerizable unsaturated bond groups in one molecule.

8. The negative photosensitive resin composition according to claim 6 or 7, comprising, as (D) a heat crosslinking agent, one or more crosslinking agents selected from the group consisting of an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (D-1), and a compound containing two or more nitrogen atoms each having a glycidyl group represented by the following formula (D-2), 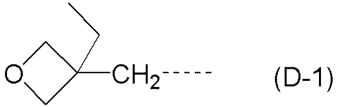 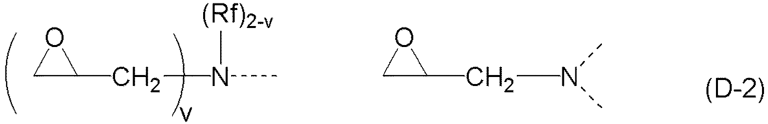 wherein a dotted line represents an attachment point; Rf represents a linear, branched, or cyclic alkyl group having 1 to 6 carbon atoms; and "v" represents 1 or 2.

9. The negative photosensitive resin composition according to any one of claims 6 to 8, further comprising one or more of (F) a protective amine compound, (G) a thermal acid generator, (H) an antioxidant, and (I) a silane compound.

10. A patterning process comprising the steps of:
(1) applying the negative photosensitive resin composition according to any one of claims 6 to 9 onto a substrate to form a photosensitive material film;
(2) heating the photosensitive material film;
(3) exposing the photosensitive material film with a high-energy beam having a wavelength of 190 to 500 nm or an electron beam through a photomask; and
(4) performing development using a developing solution of an organic solvent.

11. A method for forming a cured film, comprising heating and post-curing a patterned film obtained by the patterning process according to claim 10 at a temperature of 100 to 300°C.

12. An interlayer insulating film comprising a cured film of the negative photosensitive resin composition according to any one of claims 6 to 9.

13. A surface protective film comprising a cured film of the negative photosensitive resin composition according to any one of claims 6 to 9.

14. An electronic component comprising the interlayer insulating film according to claim 12, or
an electronic component comprising the surface protective film according to claim 13.
